# EUROPEAN PATENT SPECIFICATION

(11) **EP 3 249 684 B1**
(45) Date of publication and mention of the grant of the patent: **30.12.2020**
(21) Application number: 17167997.0
(22) Date of filing: 25.04.2017
(51) Int. Cl.: H01L 23/04

(54) **POWER MODULE**
LEISTUNGSMODUL
MODULE DE PUISSANCE

(30) Priority: 23.05.2016 CN 201610347970
(43) Date of publication of application: 29.11.2017
(73) Proprietor: Delta Electronics, Inc., Taoyuan City 33370 (TW)
(72) Inventor: Wang, Tao, Pudong, Shanghai 201209 (CN); Lu, Kai, Pudong, Shanghai 201209 (CN); Zhao, Zhenqing, Pudong, Shanghai 201209 (CN); Hong, Shouyu, Pudong, Shanghai 201209 (CN); Cheng, Wei, Pudong, Shanghai 201209 (CN)
(74) Representative: 2K Patentanwälte Blasberg Kewitz & Reichel

(56) References cited:
- FR-A1- 2 820 719
- JP-A- S5 979 562
- US-A- 5 767 447
- US-A1- 2009 104 734
- US-A1- 2012 256 194
- US-A1- 2015 289 389
- US-B1- 6 521 983

## Description

### FIELD OF THE INVENTION

The present invention relates to a power module, and more particularly to a power module having a modular housing structure.

### BACKGROUND OF THE INVENTION

Conventional power module generally has a substrate as the bottom portion. Taking a power module having the power substrate as the bottom portion for example, the main structure of the power module includes the power substrate, a power chip, a connecting material, a bonding wire, a compound, a sealing material, a metal terminal and an outer housing structure. The power chip is disposed on the power substrate by the connecting material so as to accomplish the mechanical support of the power chip and dissipate the heat via the power substrate. The metal terminal is also connected to the power substrate by the connecting material and the electrodes of the power chip are connected to the power substrate by the bonding wire so as to accomplish the circuit conduction. Consequently, circuit of the power module is electrically connected with the external power and signal circuit by the metal terminal. In the entire structure of the power module, the outer housing structure further provides an accommodation space with the sealed bottom portion to be filled with the compound, so that the compound provides a protective environment and a protective insulation around the power chip.
US 2012/256194A1 Discloses a semiconductor device having a structure capable of reducing the self-inductance of internal wiring. The semiconductor device includes: a lower board having a lower conductor layer formed on the surface thereof; a switching element bonded to the lower conductor layer in an element bonding area; a terminal bonded to the lower conductor layer in a terminal bonding area; an upper board stacked on the lower board in a board bonding area between the element bonding area and the terminal bonding area, and having an upper conductor layer on the surface thereof; and a switching element connecting member which connects the switching element with the upper conductor layer.
FR3830729 A1 discloses plastic crate walls (1, 2) which have a cross-shaped male section at one end and a cross-shaped recess at the other, allowing them to be assembled to form a frame. A separate base is then fitted into this.
US2009104734A1 discloses a method for assembling a power module includes providing a casing with a plurality of receiving elements. At least one substrate carrying at least one semiconductor chip is provided within the casing. At least one support element is provided. An elastically stressed cover is arranged over the at least one support element, and the cover is released so that the elastically stressed cover is restrained by the at least one support element and the plurality of receiving elements.
US5767447A discloses a concept wherein a bottom and side surfaces of an electronic device, such as an integrated circuit chip or a multichip assembly, are surrounded by a soft gel medium. The gel medium is laterally confined by a rigid plastic rim that is epoxy-bonded in place along its perimeter. A plate, made of plastic or metal, can be attached to the top surface of the rim, in order to provide a cover for the package.
US2015289389A1 discloses an enclosure including a plurality of modular corner segments and a plurality of modular wall segments that connect together to at least partially define an internal compartment of the enclosure. The wall segments extending lengths between opposite free ends. At least a majority of the wall segments are fabricated from a polymer. Each corner segment includes opposite first and second receiver sockets that are each configured to receive a corresponding free end of a corresponding wall segment therein to connect the corner segment to the corresponding wall segments. At least a majority of the corner segments are fabricated from a polymer. The corner segments and the wall segments connect together to define the internal compartment of the enclosure.

In the conventional power module, the outer housing structure can be divided into two types. One is the integral forming structure and another is the multiple-parts housing structure. The integral forming housing structure includes a frame vertical to the power substrate and a cover parallel to the power substrate, wherein the frame and the cover are formed into the integral forming housing. The multiple-parts housing structure includes the frame and the cover formed separately. However, the above two types of the outer housing structures applied to the conventional power module have the fixed size and the accommodation space thereof is limited, so that accommodable power substrate is limited. If the fixed outer housing structure is used to accommodate a product with lower power level, the material of the power substrate and the compound will be wasted and the power density will be decreased. Consequently, the entire cost is increased and the power density of the system is influenced. On the other hand, in correspondence to new topology or power level, for the purposes of reducing the material cost and enhancing the power density of the system, the above two types of outer housing structures have to re-mold. Consequently, it will increase the extra cost for re-molding and the managing cost of the molding tools. The entire manufacturing cost can't be reduced.

Therefore, there is a need of providing a power module having a modular housing structure to overcome the above drawbacks.

### SUMMARY OF THE INVENTION

The present invention provides a power module having a modular housing structure in accordance with claim 1. The modular housing structure has flexible number sidewalls configured to provide an adjustable assembly according to the size of the substrate, so as to prevent from the waste of space and to increase the power density. While developing the new topology or power level, there is no need of remolding a new outer housing structure for accommodating a larger substrate, and the space waste caused by accommodating a smaller substrate within the larger outer housing structure can be prevented. Consequently, the entire manufacturing cost can be reduced, the power density of the power module can be increased, and the product will be more competitive.

The modular housing structure includes modular and extendable sidewalls and covers, which are configured to package different substrates with varied sizes, so as to accomplish the entire structure with optimized strength and high power density.

The substrate includes an electronic element disposed thereon. The modular housing structure is disposed on the substrate and located around the electronic element. The modular housing structure includes a plurality of sidewalls configured to connect with each other detachably. Each sidewall includes two connecting elements disposed on two opposite ends thereof respectively. The two connecting elements of any one of the sidewalls are connected to two corresponding connecting elements of two adjacent sidewalls respectively.

The above contents of the present invention will become more readily apparent to those ordinarily skilled in the art after reviewing the following detailed description and accompanying drawings, in which:

### BRIEF DESCRIPTION OF THE DRAWINGS

FIG. 1A is an exploded view illustrating a power module according to a first example useful for understanding the present invention;
FIG. 1B is a cross sectional view illustrating the power module of FIG. 1A;
FIG. 1C is a bottom view illustrating the sidewalls and the covers of FIG. 1A;
FIG. 1D is a cross sectional view illustrating the cover of FIG. 1A;
FIG. 2 is a bottom view illustrating a modular housing structure of a power module according to a second example useful for understanding the present invention;
FIG. 3 is a bottom view illustrating a modular housing structure of a power module according to a third example useful for understanding the present invention;
FIG. 4 is a cross sectional view illustrating a power module according to a fourth example useful for understanding the present invention;
FIG. 5A is an exploded view illustrating a power module according to a fifth example useful for understanding the present invention;
FIGS. 5B and 5C are bottom views illustrating the modular housing structure of FIG. 5A in detachment and in assembly respectively;
FIG. 6 is a bottom view illustrating a modular housing structure of a power module according to a sixth example useful for understanding the present invention;
FIG. 7 is a bottom view illustrating a modular housing structure of a power module according to a seventh example useful for understanding the present invention;
FIGS. 8A and 8B are bottom views illustrating a modular housing structure in detachment and in assembly respectively according to an eighth example useful for understanding the present invention;
FIG. 9 is a bottom view illustrating a modular housing structure of a power module according to a ninth example useful for understanding the present invention;
FIG. 10 is a bottom view illustrating a modular housing structure of a power module according to a tenth example useful for understanding the present invention;
FIG. 11 is a bottom view illustrating a modular housing structure of a power module according to an eleventh example useful for understanding the present invention;
FIG. 12A is a bottom view illustrating a modular housing structure of a power module according to a twelfth example useful for understanding the present invention;
FIG. 12B is a bottom view illustrating the sidewalls and the covers of FIG. 12A;
FIG. 13A is a bottom view illustrating a modular housing structure of a power module according to a thirteenth example useful for understanding the present invention;
FIG. 13B is a bottom view illustrating the sidewalls and the covers of FIG. 13A;
FIG. 14A is a cross sectional view illustrating a power module according to a fourteenth example useful for understanding the present invention;
FIG. 14B is a top view illustrating the power module of FIG. 14A;
FIG. 15A is a cross sectional view illustrating the cover of the modular housing structure according to a first preferred embodiment of the present invention;
FIG. 15B is a top view illustrating the cover of the modular housing structure according to the first preferred embodiment of the present invention; and
FIG. 15C is a cross sectional view illustrating a power module according to a fifteenth example useful for understanding the present invention.

### DETAILED DESCRIPTION OF THE PREFERRED EMBODIMENT

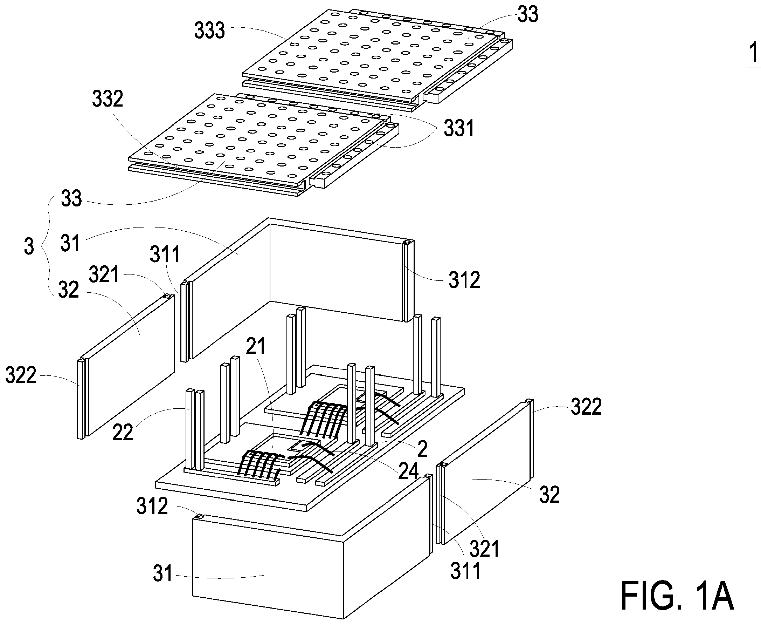

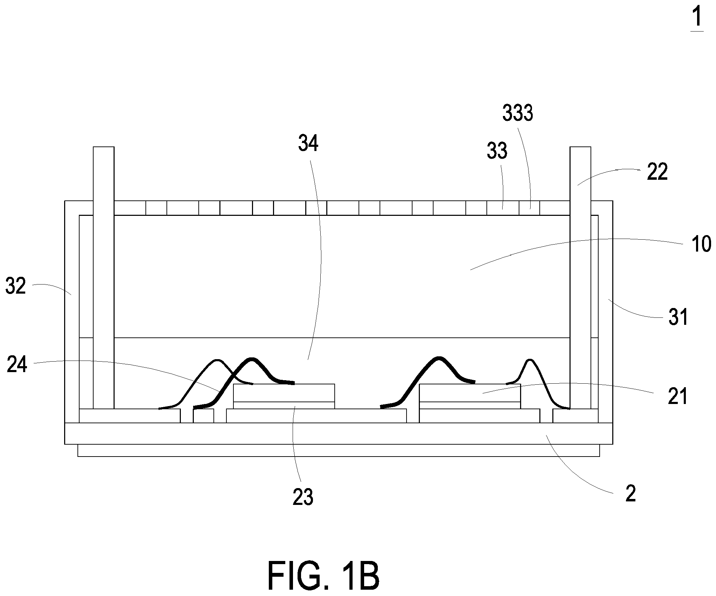

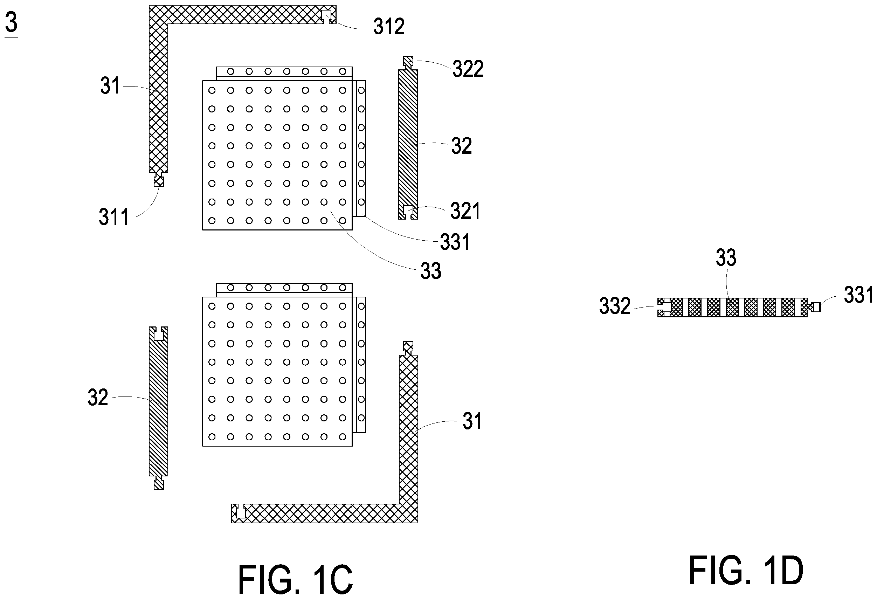

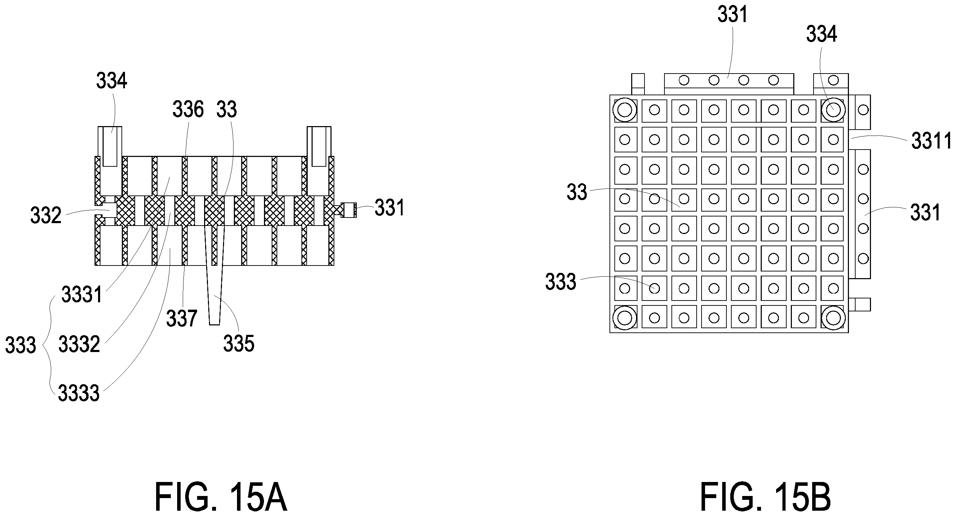

The present invention will now be described more specifically with reference to the following embodiments. In the following, only the embodiments relating to Figs.15A,B that are labelled as an "embodiment of the present invention" fall within the scope of the appended claims. All other embodiments, relating to Figs.1-14 and Fig.15C, are not in accordance with the present invention, but are to be understood as illustrative examples that are useful for understanding the present invention. It is to be noted that the following description is presented herein for purpose of illustration only. It is not intended to be exhaustive or to be limited to the precise form disclosed.

FIG. 1A is an exploded view illustrating a power module according to a first embodiment FIG. 1B is a cross sectional view illustrating the power module of FIG. 1A. FIG. 1C is a bottom view illustrating the sidewalls and the covers of FIG. 1A. FIG. ID is a cross sectional view illustrating the cover of FIG. 1A. As shown in FIGS. 1A to ID, the power module 1 including a substrate 2 and a modular housing structure 3. The substrate 2 includes at least an electronic element 21 disposed thereon. The modular housing structure 3 is disposed on the substrate 2 and located around the electronic element 21. The modular housing structure 3 includes a plurality of sidewalls configured to connect with each other detachably. Each sidewall includes two connecting elements disposed on two opposite ends thereof respectively. The two connecting elements of any one of the sidewalls are connected to two corresponding connecting elements of two adjacent sidewalls respectively.

In the embodiment, the substrate 2 includes at least one electronic element 21 and at least four sides. The plurality of sidewalls of the modular housing structure 3 include two first sidewalls 31 and two second sidewalls 32. Each sidewall is formed independently. The two first sidewalls 31 have the same structure, and each first sidewall 31 includes a first connecting element 311 and a second connecting element 312 disposed on the two opposite ends of the first sidewall 31 respectively. The two second sidewalls 32 may have the same structure, and each second sidewall 32 includes a third connecting element 321 and a fourth connecting element 322 disposed on the two opposite ends of the second sidewall 32 respectively. In the embodiment, the first connecting elements 311 of the first sidewalls 31 and the third connecting elements 321 of the second sidewalls 32 are structures which can be assembled with each other. Similarly, the second connecting elements 312 of the first sidewalls 31 and the fourth connecting elements 322 of the second sidewalls 32 are matching structures and configured to connect with each other. Preferably, each first connecting element 311 and each second connecting element 312 can be a protrusion and a recess respectively; and each third connecting element 321 and each fourth connecting element 322 can be a recess and a protrusion respectively. The protrusion and the recess are matching structures and configured to be engaged or connected with each other. Alternatively, each first connecting element 311 and each second connecting element 312 can be a recess and a protrusion respectively; and each third connecting element 321 and each fourth connecting element 322 can be a protrusion and a recess respectively. In this embodiment, the first connecting element 311 may have the same or different shape with the fourth connecting element 322, and the second connecting element 312 may have the same or different shape with the third connecting element 321. In the embodiment, the two first sidewalls 31 and the two second sidewalls 32 are connected in a staggered arrangement, for example, as shown in FIG. 1C. Any two adjacent sidewalls have the end-to-end connection with each other, so that the two first sidewalls 31 and the two second sidewalls 32 are assembled together, disposed on the four sides of the substrate 2 and located around the electronic element 21 of the substrate 2. Describing in detail, any one of the first sidewalls 31 has the first connecting element 311 detachably connected to the third connecting element 321 of the adjacent second sidewall 32, and has the second connecting element 312 detachably connected to the fourth connecting element 322 of another adjacent second sidewall 32. Similarly, any one of the second sidewalls 32 has the third connecting element 321 detachably connected to the first connecting element 311 of the adjacent first sidewall 31, and has the fourth connecting element 322 detachably connected to the second connecting element 312 of another adjacent first sidewall 31. Consequently, the two first sidewalls 31 and the two second sidewalls 32 are assembled and configured to define an accommodation space 10. The electronic element 21 of the substrate 2 is accommodated in the accommodation space 10. In the embodiment, each first sidewall 31 has two portions vertically connected to each other and each portion may have the same length. Namely, the first sidewall 31 is an L-shaped sidewall. Each second sidewall 32 is formed by one portion and the portion of the second sidewall 32 may have the same length with the portion of the first sidewall 31. Namely, the second sidewall 32 is flat-plate sidewall. The two first sidewalls 31 and the two second sidewalls 32 are vertically connected with the substrate 2 respectively. The modular housing structure 3 may further include one cover and the cover is in shape of a rectangular.

In the embodiment, the modular housing structure 3 further includes two covers 33 connected with the plurality of sidewalls. The two covers 33 are both opposite and parallel to the substrate 2. The two covers 33 have same structures, such as a shape of a square, and each of the covers 33 includes two first engaging elements 331 and two second engaging elements 332. The two first engaging elements 331 are disposed on two adjacent sides of the cover 33 and the two second engaging elements 332 are disposed on another two adjacent sides of the cover 33. The first engaging element 331 of any one of the covers 33 is connected with the second engaging element 332 of the other cover 33 so as to connect two covers 33 and form a plate cover body.

In the embodiment, the two covers 33 form the plate cover body and are further connected to the two first sidewalls 31 and two second sidewalls 32 by means of for example but not limited to buckle or adhesive. The substrate 2 can be attached to the modular housing structure 3 by means of for example but not limited to buckle or adhesive. In the embodiment, the power module 1 further includes a plurality of metal terminals 22 electrically connected to the substrate 2, and each cover 33 includes a plurality of through-openings 333. Each metal terminal 22 has an end electrically connected to the substrate 2 and another end passing through the corresponding through-opening 333 of the cover 33 so that the metal terminal 22 is partially exposed from the outer surface of the cover 33. Certainly, the metal terminal 22 can be led out by a lot of methods not limited to the above embodiment. In some embodiments, the first sidewall 31 and/or the second sidewall 32 can have sidewall through-opening (not shown) for allowing the metal terminal 22 to pass therethrough, but it is not limited thereto. In other embodiment, the plurality of the though-openings 333 are arranged in arrays so as to facilitate the metal terminal 22 to pass through in different places and accomplish the circuit design with the optimized loop. It is noted that, the numbers of the first sidewalls 31, the second sidewalls 32, and the covers 33 are not limited to the above embodiments and can be adjusted and varied according the practical requirements.

In the embodiment, the substrate 2 can be for example but not limited to a power substrate. The substrate 2 can be constructed by a direct bonding copper (DBC) substrate, a direct bonding aluminum (DBA) substrate, a low-temperature co-fired ceramic (LTCC) substrate, a direct plated copper (DPC) substrate, an insulated metal substrate (IMS), a printed circuit board (PCB) or a lead frame (LF). In some embodiments, the substrate 2 further includes a conductive layer and an insulation layer. The conductive layer can be constructed by gold, silver, copper, copper-aluminum compound materials, gold-platinum, palladium-gold, palladium-silver, platinum-sliver, or palladium-copper-silver materials. The insulation layer can be constructed by alumina, aluminum nitride, silicon nitride or beryllium oxide ceramic materials, or epoxy or silicon based organic materials. The electronic element 21 can be for example but not limited to a power semiconductor chip or a power device such as an insulated gate bipolar transistor (IGBT), a metal-oxide-semiconductor field-effect transistor (MOSFET) and an integrated gate commutated thyristor (IGCT). The electronic element 21 is connected to the top surface of the substrate 2 by a connecting material 23. In the embodiment, the connecting material 23 can be for example but not limited to solder, an intermetallic compound, low-temperature-sintering materials, or conductive silver paste. Moreover, the electronic element 21 has the conductive electrodes or terminals electrically connected to the substrate 2 by a conductive element 24. The conductive element 24 can be accomplished by means of wire-bonding technology or wireless-bonding technology. The wire-bonding technology can be constructed by for example but not limited to aluminum wire, copper wire, aluminum-copper compound, gold wire, and such metal wire by ultrasonic bonding so as to accomplish the electrical connection. The wireless-bonding technology can be for example but not limited to aluminum ribbon bonding, metal-metal direct bonding, or copper clip bonding so as to obtain the electrical connection. Moreover, the aluminum ribbon bonding can be accomplished by means of ultrasonic bonding. The metal-metal direct bonding can be accomplished by means of ultrasonic welding technology and the metal can be for example but not limited to silver, copper, aluminum or gold. The copper clip bonding can be accomplished by using connecting materials as copper clip electrically connected between the chip and the conductive layer of the substrate, and the connecting materials can be for example but not limited to solder, low-temperature-sintering materials, or conductive silver paste.

In the embodiment, the power module 1 further includes a compound 34 disposed on the substrate 2 and the compound 34 is filled in the accommodation space 10 formed by the modular housing structure 3, so as to cover and protect the electronic element 21 on the substrate 2. Consequently, the package of the power module 1 is accomplished. The compound 34 can be constructed by for example but not limited to epoxy materials. In some embodiments, the plurality of metal terminals 22 which are conducted from the substrate 2 pass through the compound 34 and the through-opening 333 of the cover 33 and are led out.

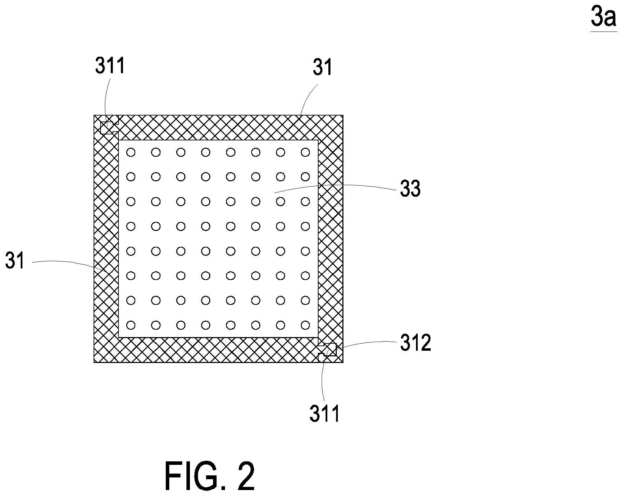

FIG. 2 is a bottom view illustrating a modular housing structure of a power module according to a second embodiment. In the embodiment, the structures, elements and functions of the modular housing structure 3a are similar to those of the modular housing structure 3 in FIGS. 1A to ID, and are not redundantly described herein. There are also a plurality of sidewalls assembled with each other detachably and conjured to form a closed accommodation space, so as to accommodate the electronic elements and the compound. Different from the modular housing structure 3 of FIGS. 1A to ID, the modular housing structure 3a omits two second sidewalls 32 and one cover 33. Namely, the modular housing structure 3a includes two first sidewalls 31 and a cover 33. Similarly, the first connecting element 311 of the first sidewall 31 and the second connecting element 312 of the first sidewall 31 are matching structures. Consequently, the first connecting element 311 of any one of the first sidewall 31 is connected with the second connecting element 312 of the other first sidewall 31. The second connecting element 312 of the first sidewall 31 is connected to the first connecting element 311 of the other first sidewall 31. The two first sidewalls 31 are connected with each other. In the embodiment, each first connecting element 311 and each second connecting element 312 can be a protrusion and a recess respectively. The above mentioned protrusion and recess are matching structures and configured to engaged or connected with each other. Alternatively, each first connecting element 311 and each second connecting element 312 can be a recess and a protrusion respectively. In the embodiment, the power module 1 has the substrate 2 at half size of the substrate 2 of FIGS. 1A to ID. The substrate 2 may be in a shape of a square and the accommodation space 10 formed by the modular housing structure 3 may be in a shape of a square. The cover 33 may be in a shape of a square. But the disclosure is not limited thereto

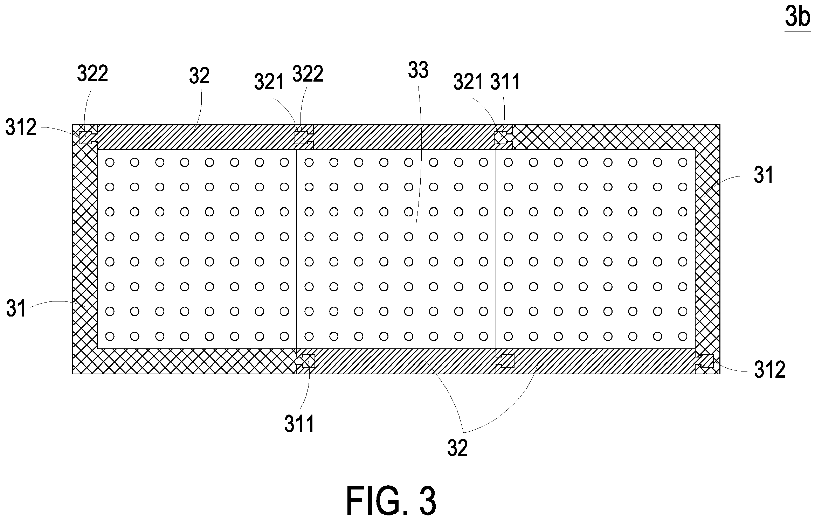

FIG. 3 is a bottom view illustrating a modular housing structure of a power module according to a third embodiment. In the embodiment, the structures, elements and functions of the modular housing structure 3b are similar to those of the modular housing structure 3 in FIGS. 1A to ID, and are not redundantly described herein. Different from the modular housing structure 3 of FIGS. 1A to ID, the modular housing structure 3b further adds two second sidewalls 32 and one cover 33. Namely, the modular housing structure 3b includes two first sidewalls 31, four second sidewalls 32 and three covers 33. In the embodiment, each third connecting element 321 and each fourth connecting element 322 of the second sidewalls 32 are matching structures. Consequently, the third connecting element 321 of one of second sidewalls 32 is connected and engaged with the fourth connecting element 322 of another one of the second sidewalls 32. The fourth connecting element 322 of one of second sidewalls 32 is connected and engaged with the third connecting element 321 of another one of the second sidewalls 32. In this embodiment, the first connecting element 311 may have the same shape with the fourth connecting element 322, and the second connecting element 312 may have the same shape with the third connecting element 321. Two of the second sidewalls 32 can be connected with each other so as to extend the length thereof. In the embodiment, the modular housing structure 3b has two first sidewalls 31 and four second sidewalls 32 connected together. Two ends of each first sidewall 31 are connected with two second sidewall 32 respectively. For each second sidewall 32, one end is connected with a first sidewall 31 and another end is connected with another second sidewall 32. Consequently, the modular housing structure 3b is extended along single axis. Afterward, the three covers 33 are connected to the two first sidewalls 31 and the four second sidewalls 32. According to the above embodiments, the power module 1 of the present invention can be configured to package the substrates 2 at different sizes by means of adjusting the numbers and connections of the first sidewalls 31, the second sidewalls 32 and the covers 33, so as to avoid the waste of space and enhance the power density.

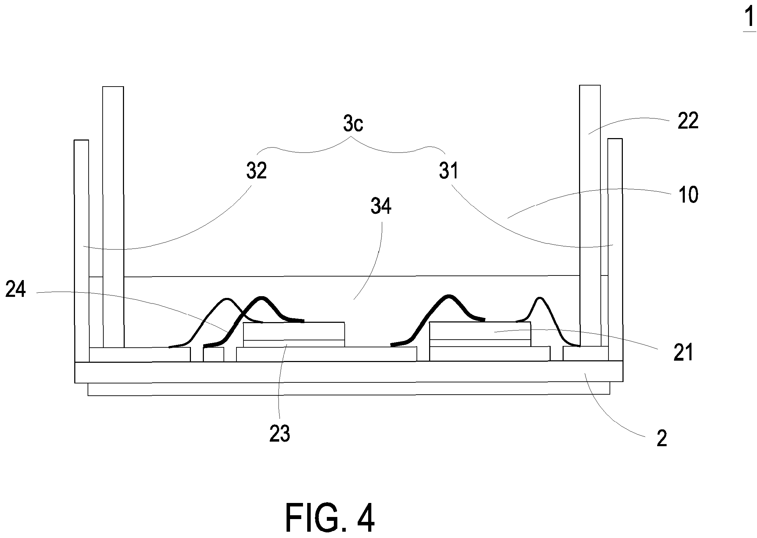

FIG. 4 is a cross sectional view illustrating a power module according to a fourth embodiment. In the embodiment, the structures, elements and functions of the modular housing structure 3c are similar to those of the modular housing structure 3 in FIGS. 1A to ID, and are not redundantly described herein. Different from the modular housing structure 3 of FIGS. 1A to ID, the modular housing structure 3c omits the covers 33. In the embodiment, the compound 34 is disposed in the accommodation space 10 of the modular housing structure 3c. The compound 34 covers and protects the electronic element 21 on the substrate 2, and further fixes the plurality of metal terminals 22. Consequently, the covers of the power module 1 of the present invention can be omitted according to the practical requirement so as to further reduce the manufacturing cost.

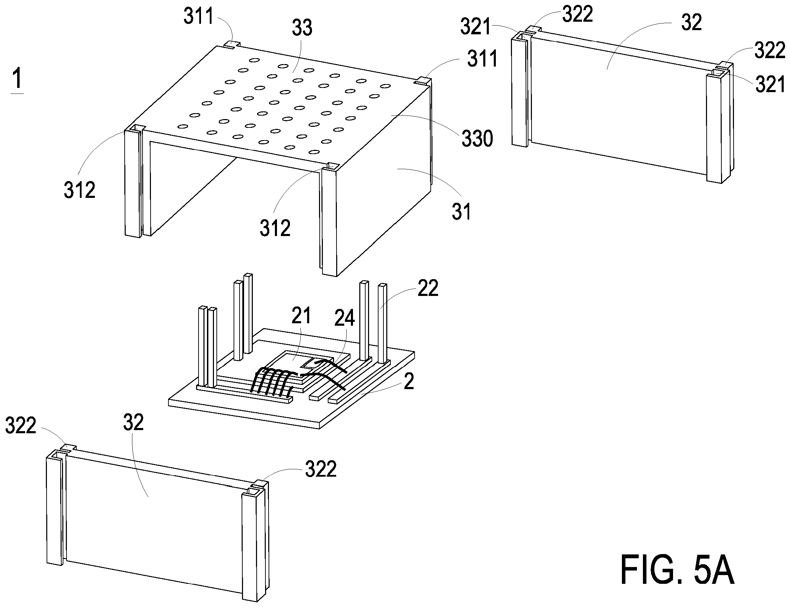

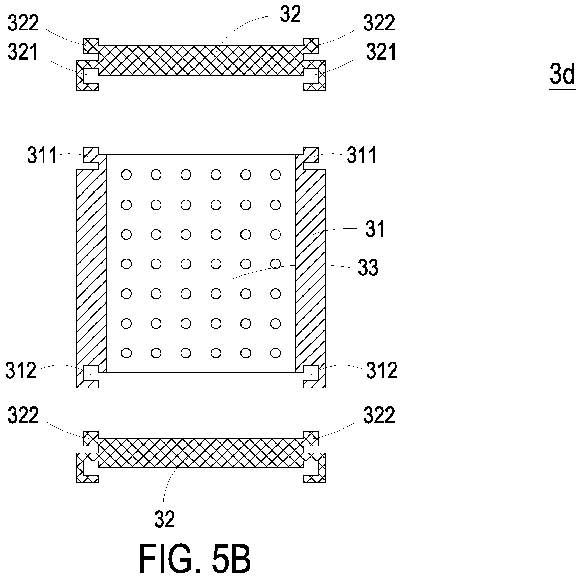

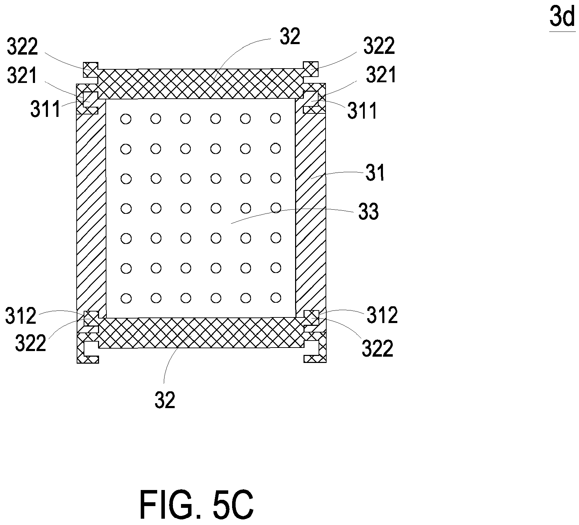

FIG. 5A is an exploded view illustrating a power module according to a fifth embodiment. FIGS. 5B and 5C are bottom views illustrating the modular housing structure of FIG. 5A in detachment and in assembly respectively. In the embodiment, the structures, elements and functions of the modular housing structure 3d are similar to those of the modular housing structure 3 in FIGS. 1A to ID, and are not redundantly described herein. Different from the modular housing structure 3 of FIGS. 1A to ID, the modular housing structure 3d includes two first sidewalls 31, two second sidewalls and a cover 33. The first sidewalls 31 are I-shaped sidewalls. The two first sidewalls 31 are integrally formed into one piece with the cover 33 and the two first sidewalls 31 are disposed on two opposite first sides 330 of the cover 33 respectively. In the embodiment, both of the first sidewalls 31 have one first connecting element 311 and one second connecting element 312. The first connecting element 311 and the second connecting element are disposed on two ends of each first sidewall 31 respectively. The two first connecting elements 311 of the two first sidewalls 31 are both located at the one side of the cover 33 and adjacent to one second sidewall 32. The two second connecting elements 312 of the two first sidewalls 31 are both located at another side of the cover 33 and adjacent to another second sidewall 32. A third connecting element 321 and a fourth connecting element 322 disposed on each end of each second sidewall 32. Namely, each second sidewall 32 has two third connecting elements 321 disposed on two ends of the second sidewall 32 and two fourth connecting elements 322 disposed on the two ends of the second sidewall 32. In this embodiment, the first connecting element 311 may have the same or different shape with the fourth connecting element 322, and the second connecting element 312 may have the same or different shape with the third connecting element 321. As shown in FIG. 5C, the two first connecting elements 311 of a first sidewall 31 are detachably connected with the corresponding third connecting elements 321 of a second sidewall 32. The two second connecting elements 312 of the first sidewall 31 are detachably connected with the corresponding fourth connecting elements 322 of another second sidewall 32. Consequently, the modular housing structure 3d is constructed. It is noted that the numbers of the cover 33 and the first sidewalls 31 to form the integrated structure are not limited to the above embodiment. In addition, the dispatching location of the first connecting elements 311, the second connecting elements 312, the third connecting elements 321 and the fourth connecting elements 322 is not limited to the above embodiment. In other embodiment, the first connecting element 311 of one of the first sidewalls 31 and the second connecting element 312 of another one of the first sidewalls 31 may be located at the same side of the cover 33. The second sidewall 32 may have two third connecting elements 321 located at different sides thereof respectively. The second sidewall 32 may have the two fourth connecting elements 322 located at different sides thereof respectively.

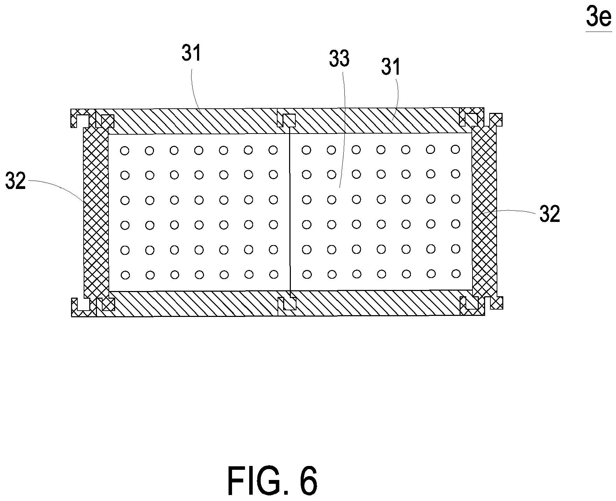

FIG. 6 is a bottom view illustrating a modular housing structure of a power module according to a sixth embodiment. In the embodiment, the structures, elements and functions of the modular housing structure 3e are similar to those of the modular housing structure 3d in FIGS. 5A to 5C, and are not redundantly described herein. Different from the modular housing structure 3d of FIGS. 5A to 5C, the modular housing structure 3e is formed by adding one more set of one cover 33 and two first sidewalls 31. Moreover, the modular housing structure 3e is configured to package the corresponding substrate 2 whose size is two times as that of the substrate 2 of FIG. 5A. In the embodiment, the added set of one cover 33 and two first sidewalls 31 are formed into one piece and is connected with another set of one cover 33 and two first sidewalls 31 formed into one piece. Afterward, two second sidewalls 32 are assembled with the above structure so as to accomplish the modular housing structure 3e. But the disclosure is not limited thereto, for example, the set of one cover 33 and two first sidewalls 31 may be formed with detachable parts.

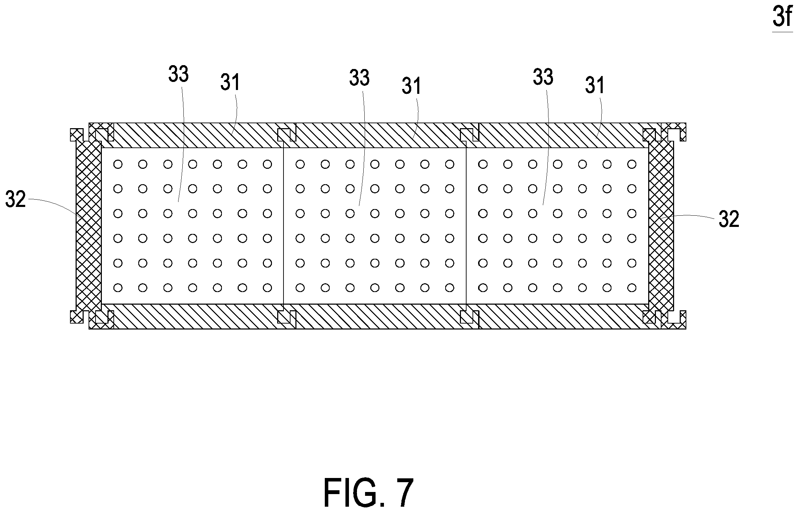

FIG. 7 is a bottom view illustrating a modular housing structure of a power module according to a seventh embodiment. In the embodiment, the structures, elements and functions of the modular housing structure 3f are similar to those of the modular housing structure 3d in FIGS. 5A to 5C, and are not redundantly described herein. Different from the modular housing structure 3d of FIGS. 5A to 5C, the modular housing structure 3f includes three sets of one cover 33 and two first sidewalls 31 formed into one piece, and two second sidewalls 32. The modular housing structure 3f is configured to package the corresponding substrate 2 whose size is three times as that of the substrate 2 of FIGS. 5A to 5C. In the embodiment, three sets of one cover 33 and two first sidewalls 31 formed into one piece are assembled together so as to extend along single axis. Afterward, two second sidewalls 32 are assembled with the above structure so as to accomplish the modular housing structure 3f. According to the above embodiments, the power module 1 can be configured to package the substrates 2 at different sizes by means of adjusting the numbers and the connections of the one-piece sets formed by the cover 33 and the first sidewalls 31, so as to avoid the waste of space and enhance the power density.

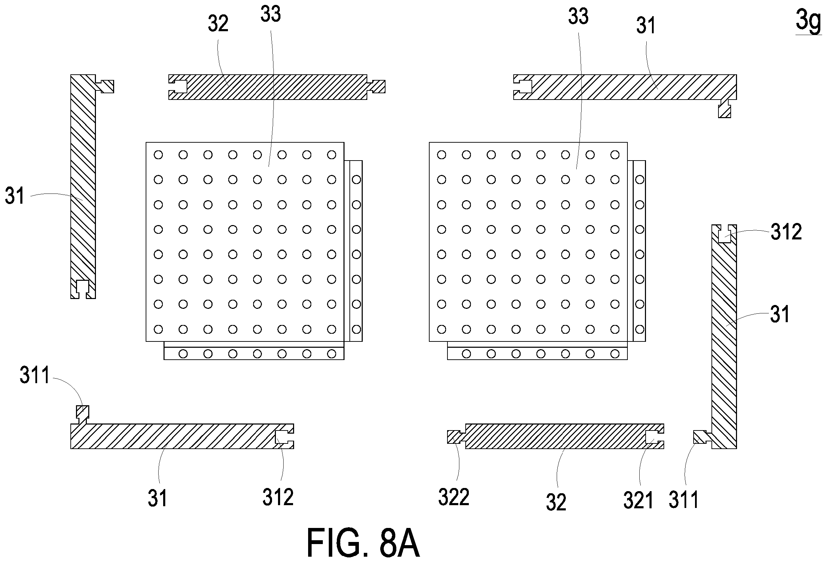

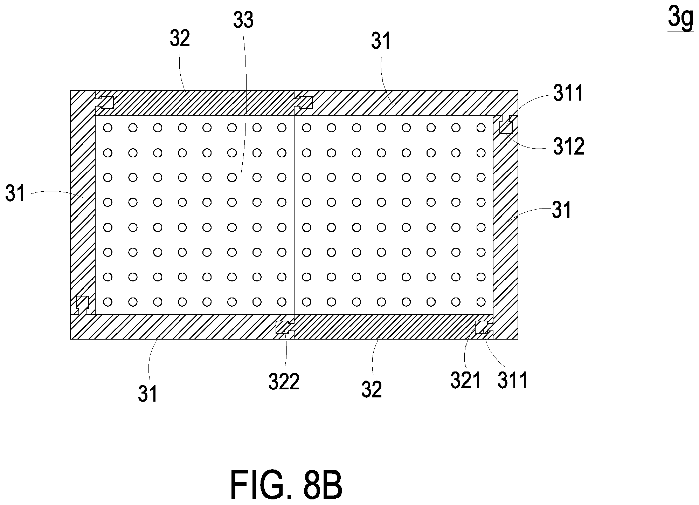

FIGS. 8A and 8B are bottom views illustrating a modular housing structure in detachment and in assembly respectively according to an eighth embodiment. In the embodiment, the structures, elements and functions of the modular housing structure 3g are similar to those of the modular housing structure 3 in FIGS. 1A to ID, and are not redundantly described herein. Different from the modular housing structure 3 of FIGS. 1A to ID, the modular housing structure 3g includes four first sidewalls 31, two second sidewalls 32 and two covers 33. The four first sidewalls 31 and the two second sidewalls 32 are I-shaped sidewalls and configured to package the similar substrate 2 illustrated in FIGS. 1A to 1D. In the embodiment, the four first sidewalls 31 are the same, and each first sidewall 31 includes a first connecting element 311 and a second connecting element 312 disposed on the two opposite ends of the first sidewall 31 respectively. The first connecting element 311 of the first sidewall 31 and the second connecting element 312 of the first sidewall 31 are matching structures. In the embodiment, any one of the first sidewalls 31 has the first connecting element 311 configured to match and connect with the second connecting element 312 of another one of the first sidewalls 31, and any one of the first sidewalls 31 has the second connecting element 312 configured to match and connect with the first connecting element 311 of another one of the first sidewalls 31. Consequently, two first sidewalls 31 can be assembled with each other. On the other hand, the two second sidewalls 32 are the same, and each second sidewall 32 includes a third connecting element 321 and a fourth connecting element 322 disposed on the two opposite ends of the second sidewall 32 respectively. The first connecting element 311 of one first sidewall 31 is configured to connect and engage with the third connecting element 321 of another one of the second sidewall 32. The second connecting element 312 of the first sidewall 31 is configured to connect and engage with the fourth connecting element 322 of one of the second sidewall 32. Consequently, the first sidewall 31 can be assembled with the second sidewall 32. That means, in this embodiment, the first connecting element 311 may have the same shape with the fourth connecting element 322, and the second connecting element 312 may have the same shape with the third connecting element 321. As shown in FIGS. 8A and 8B, the four first sidewalls 31 and the two second sidewalls 32 are assembled and located around the at least four sides of the substrate 2, and the two covers 33 are attached thereon, so as to accomplish the modular housing structure 3g. It is noted that the numbers of the first sidewalls 31, the second sidewalls 32 and the covers 33 are not limited to the above embodiment.

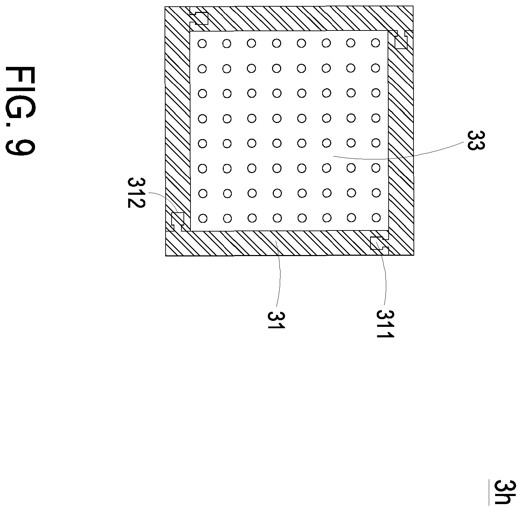

FIG. 9 is a bottom view illustrating a modular housing structure of a power module according to a ninth embodiment. In the embodiment, the structures, elements and functions of the modular housing structure 3h are similar to those of the modular housing structure 3g in FIGS. 8A to 8B, and are not redundantly described herein. Different from the modular housing structure 3g of FIGS. 8A to 8B, the modular housing structure 3h omits two second sidewalls 32. The modular housing structure 3h is configured to package the corresponding substrate 2 which is half as the substrate 2 of FIGS. 8A to 8B. In the embodiment, the four I-shape first sidewalls 31 are assembled together and connected with the cover 33 so as to accomplish the modular housing structure 3h.

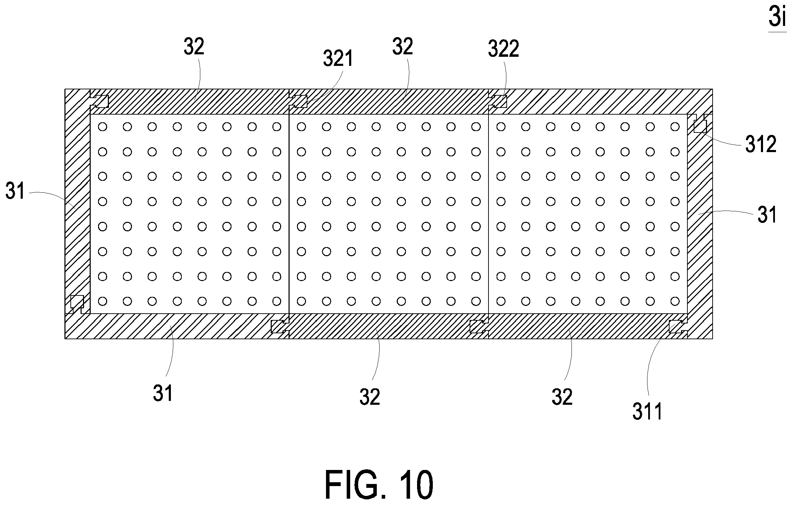

FIG. 10 is a bottom view illustrating a modular housing structure of a power module according to a tenth embodiment. In the embodiment, the structures, elements and functions of the modular housing structure 3i are similar to those of the modular housing structure 3g in FIGS. 8A to 8B, and are not redundantly described herein. Different from the modular housing structure 3g of FIGS. 8A to 8B, the modular housing structure 3i further adds two second sidewalls 32 and one cover 33. In the embodiment, the third connecting element 321 of the second sidewall 32 and the fourth connecting element 321 of the second sidewall 32 are matching structures. Any one of the second sidewalls 32 has the third connecting element 321 configured to match and connect with the fourth connecting element 322 of another one of the second sidewalls 32 or the first connecting element 311 of one first sidewall 31, and any one of the second sidewalls 32 has the fourth connecting element 322 configured to match and connect with the third connecting element 321 of the other one of the second sidewalls 32 or the second connecting element 312 of one first sidewall 31. That means, in this embodiment, the first connecting element 311 may have the same shape with the fourth connecting element 322, and the second connecting element 312 may have the same shape with the third connecting element 321. Consequently, two second sidewalls 31 can be connected with each other and the modular housing structure 3i is extended. The modular housing structure 3i in FIG. 10 is configured to package the corresponding substrate 2 whose size is one and half times as that of the substrate 2 of FIGS. 8A to 8B. In the embodiment, the four first sidewalls 31 and four second sidewalls 32 are assembled together and connected with the three cover 33 so as to accomplish the modular housing structure 3i.

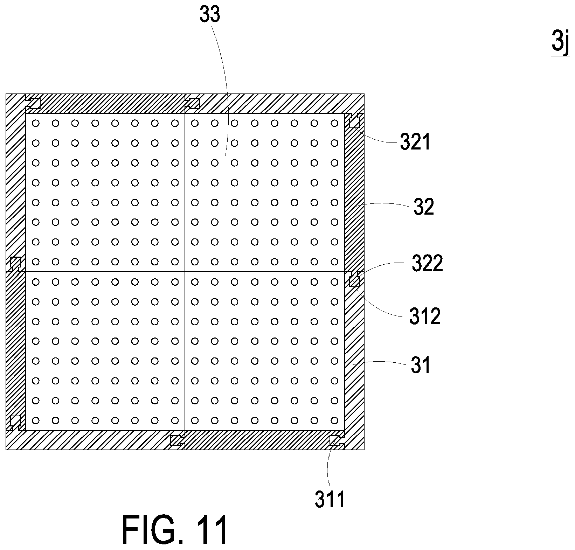

FIG. 11 is a bottom view illustrating a modular housing structure of a power module according to an eleventh embodiment. In the embodiment, the structures, elements and functions of the modular housing structure 3j are similar to those of the modular housing structure 3g in FIGS. 8A to 8B, and are not redundantly described herein. Different from the modular housing structure 3g of FIGS. 8A to 8B, the modular housing structure 3j further adds two second sidewalls 32 and two covers 33. Moreover, the modular housing structure 3j is configured to package the corresponding substrate 2 whose size is two times as that of the substrate 2 of FIGS. 8A and 8B. In the embodiment, the four first sidewalls 31 and the four second sidewalls 32 are connected and assembled together. The four covers 33 are assembled in arrays. The above sidewalls are connected with the covers so as to accomplish the modular housing structure 3j. According to the above embodiments, the power module 1 of the present invention can be configured to package the substrates 2 at different sizes by means of adjusting the numbers and connections of the first sidewalls 31, the second sidewalls 32 and the covers 33, so as to avoid the waste of space and enhance the power density.

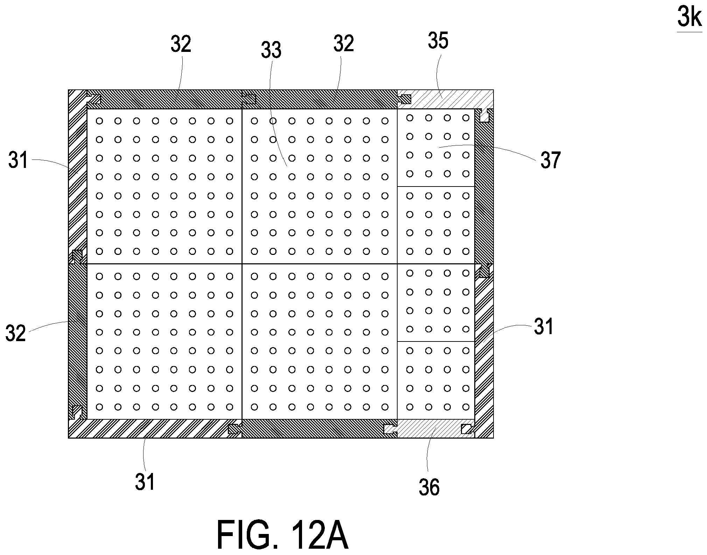

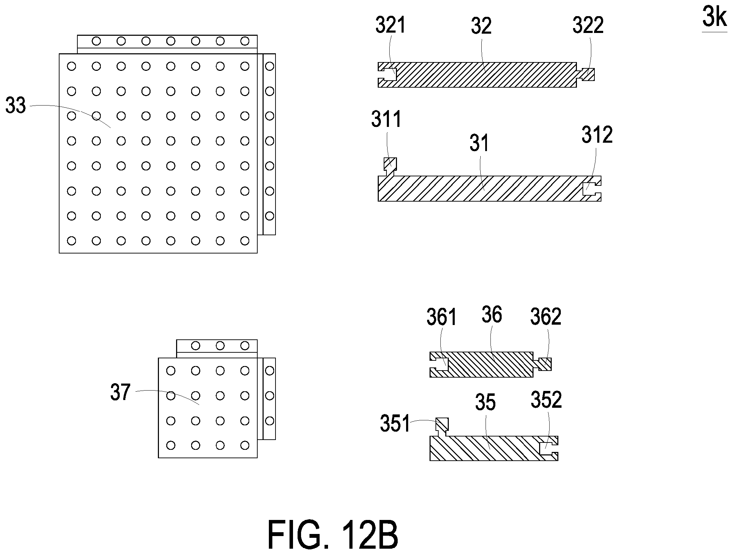

FIG. 12A is a bottom view illustrating a modular housing structure of a power module according to a twelfth embodiment. FIG. 12B is a bottom view illustrating the sidewalls and the covers of FIG. 12A. In the embodiment, the structures, elements and functions of the modular housing structure 3k are similar to those of the modular housing structure 3i in FIG. 10, and are not redundantly described herein. Different from the modular housing structure 3i of FIG. 10, the modular housing structure 3k includes at least two sets of sidewalls with different lengths. In the embodiment, the first sidewall 31 and the second sidewall 32 have the same length. The third sidewall 35 and the fourth sidewall 36 have the same length but different from that of the first sidewall 31 and the second sidewall 32. Consequently, in the modular housing structure 3k, the numbers and the connections of the sidewalls may be adjustable according to the size of the substrate 2, so as to avoid the waste of space and enhance the power density. In the embodiment, the modular housing structure 3k includes three first sidewalls 31, five second sidewalls 32, one third sidewall 35, one fourth sidewall 36, four first covers 33 and four second covers 37 for packaging the substrate 2. In the embodiment, the three first sidewalls 31 have the same structure, and each first sidewall 31 includes a first connecting element 311 and a second connecting element 312 disposed on the two opposite ends of the first sidewall 31 respectively. The five second sidewalls 32 have the same structure, and each second sidewall 32 includes a third connecting element 321 and a fourth connecting element 322 disposed on the two opposite ends of the second sidewall 32 respectively. The third sidewall 35 includes a fifth connecting element 351 and a sixth connecting element 352 disposed on the two opposite ends of third sidewall 35 respectively. The fourth sidewall 36 includes a seventh connecting element 361 and an eighth connecting element 362 disposed on the two opposite ends of fourth sidewall 36 respectively. In the embodiment, the third sidewall 35 and the first sidewall 31 have a similar structure but the length of the third sidewall 35 is half of the length of the first sidewall 31. The structures of the fifth connecting element 351 and the sixth connecting element 352 are as same as the structures of the first connecting element 311 and the second connecting element 312 respectively. The fourth sidewall 36 and the second sidewall 32 have a similar structure but the length of the fourth sidewall 36 is half of the length of the second sidewall 32. The structures of the seventh connecting element 361 and the eighth connecting element 362 are as same as the structures of the third connecting element 321 and the fourth connecting element 322 respectively. Moreover, the first cover 33 and the second cover 37 have similar structures but the length and the width of the second cover 37 are half of the length and the width of the first cover 33 respectively. In the embodiment, the fifth connecting element 351 of the third sidewall 35 is configured to match and detachably connect with the third connecting element 321 of the adjacent second sidewall 32, and the sixth connecting element 352 of the third sidewall 35 is configured to match and detachably connect with the fourth connecting element 322 of the other adjacent second sidewall 32. The seventh connecting element 361 of the fourth sidewall 36 is configured to match and detachably connect with the first connecting element 311 of the adjacent first sidewall 31, and the eighth connecting element 362 of the fourth sidewall 36 is configured to match and detachably connect with the third connecting element 321 of the adjacent second sidewall 32. As shown in FIG. 12A and FIG. 12B, the three first sidewalls 31, the five second sidewalls 32, the third sidewall 35 and the fourth sidewall 36 are connected in series and located around the four sides of the corresponding substrate 2, and then the assembly of four first covers 33 and four second covers 37 is connected thereon. Consequently, the modular housing structure 3k is accomplished. The modular housing structure 3k in FIG. 12A is configured to package the corresponding substrate 2 whose size is two and half times as that of the corresponding substrate 2 packaged by the modular housing structure 3g in FIGS. 8A to 8B. It is noted that the numbers and the connections of the first sidewalls 31, the second sidewalls 32, the third sidewalls 36, the fourth sidewalls 37, the first covers 33 and the second covers 37 are not limited to the above embodiments and can be adjusted and varied according the practical requirements. In other embodiment, for packaging the specific substrate with different length and width, the first sidewalls 31, the second sidewalls 32, the third sidewalls 35 and the fourth sidewalls 36 may be connected in series and located around the sides of the substrate 2, and the assembly of the first covers 33 and the second covers 37 corresponding to the size of the substrate 2 is attached thereto. Consequently, the package for several substrates 2 having different sizes can be accomplished.

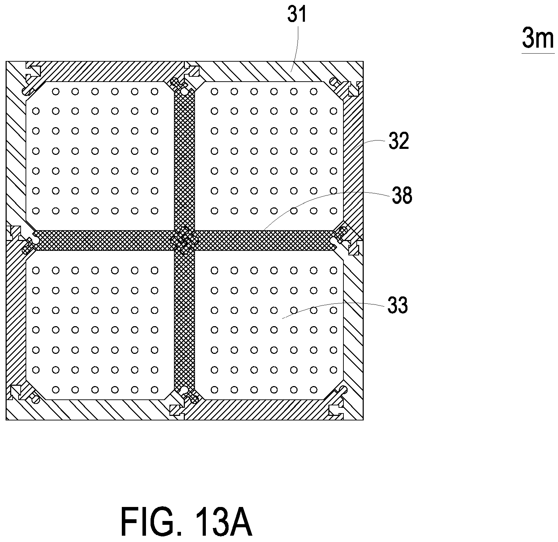

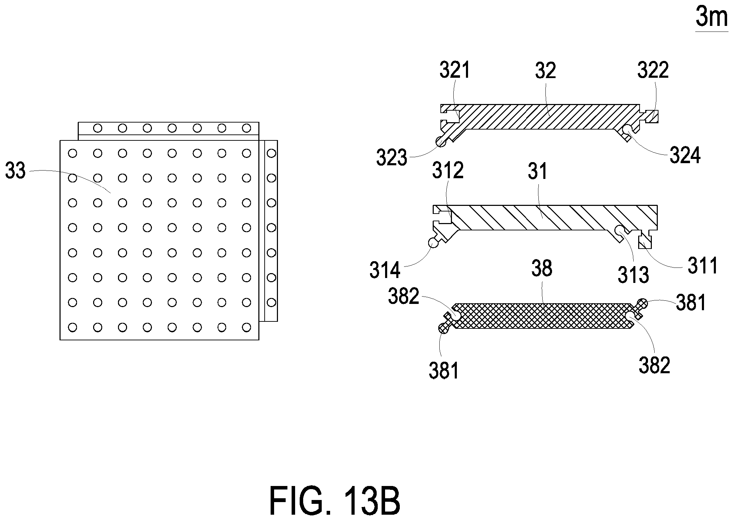

FIG. 13A is a bottom view illustrating a modular housing structure of a power module according to a thirteenth embodiment. FIG. 13B is a bottom view illustrating the sidewalls and the covers of FIG. 13A. In the embodiment, the structures, elements and functions of the modular housing structure 3m are similar to those of the modular housing structure 3j in FIG. 11, and are not redundantly described herein. Different from the modular housing structure 3j of FIG. 11, the modular housing structure 3m further includes at least an auxiliary wall 38, for example four auxiliary walls 38. Each auxiliary wall 38 includes two first auxiliary connecting elements 381 and two second auxiliary connecting elements 382. The two first auxiliary connecting elements 381 are disposed on two ends of the auxiliary wall 38 respectively, and the two second auxiliary connecting elements 382 are disposed on two ends of the auxiliary wall 38 respectively. Each first sidewall 31 further includes a third auxiliary connecting element 313 and a fourth auxiliary connecting element 314 disposed on two ends thereof respectively. Each second sidewall 32 further includes a fifth auxiliary connecting element 323 and a sixth auxiliary connecting element 324 disposed on two ends thereof. In the embodiment, the structure of the first auxiliary connecting element 381 of the auxiliary wall 38 is matching to that of the second auxiliary connecting element 382 and the sixth auxiliary connecting element 324 of the second sidewall 32 respectively. The structure of the second auxiliary connecting element 382 of the auxiliary wall 38 is matching to that of the first auxiliary connecting element 381 and the fourth auxiliary connecting element 314 of the first sidewall 31 respectively. Furthermore, the structure of any third auxiliary connecting element 313 of the first sidewall 31 is matching to that of any fifth auxiliary connecting element 323 of the second sidewall 32 respectively. In the embodiment, the first auxiliary connecting element 381, the fourth auxiliary connecting element 314 and the fifth auxiliary connecting element 323 can be constructed by a protrusion respectively. The second auxiliary connecting element 382, the third auxiliary connecting element 313 and the sixth auxiliary connecting element 324 can be constructed by a recess respectively. The protrusion and the recess are matching structures and configured to engaged or connected with each other. In the embodiment, any one of the auxiliary wall 38 has one first auxiliary connecting element 381 and one second auxiliary connecting element 382 disposed on one end of the auxiliary wall 38 and respectively connected to the second auxiliary connecting element 382 and the first auxiliary connecting element 381 disposed on the other auxiliary walls 38, and this end of the auxiliary wall 38 can be assigned as a first end. In addition, any one of the auxiliary wall 38 has another first auxiliary connecting element 381 and another second auxiliary connecting element 382 disposed on another end of the auxiliary wall 38 and respectively connected to the sixth auxiliary connecting element 324 of the second sidewall 32 and the fourth auxiliary connecting element 314 of the first sidewall 31, and this end of the auxiliary wall 38 can be assigned as a second end. Each first sidewall 31 further has the third auxiliary connecting element 313 configured to connect with the fifth auxiliary connecting element 323 of the second sidewall 32. It is noted that the numbers of the first sidewalls 31, the second sidewalls 32, the auxiliary walls 38 and the covers 33 are not limited to the above embodiment. Moreover, the dispatching locations of the first auxiliary connecting elements 381, the second auxiliary connecting elements 382, the third auxiliary connecting elements 313, the fourth auxiliary connecting elements 314, the fifth auxiliary connecting elements 323 and the sixth auxiliary connecting elements 324 are adjustable according to the dispatching location of the electronic element 21 on the substrate 2. Comparing the embodiment with the above ones, the auxiliary walls 38 are further introduced into the modular housing structure 3m so as to increase the mechanical strength thereof and further accomplish the compartment application of the accommodation space 10 in the power module 1.

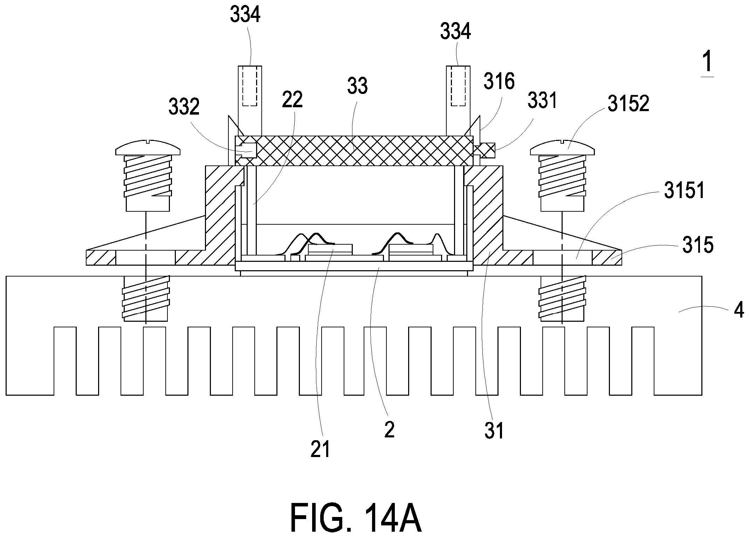

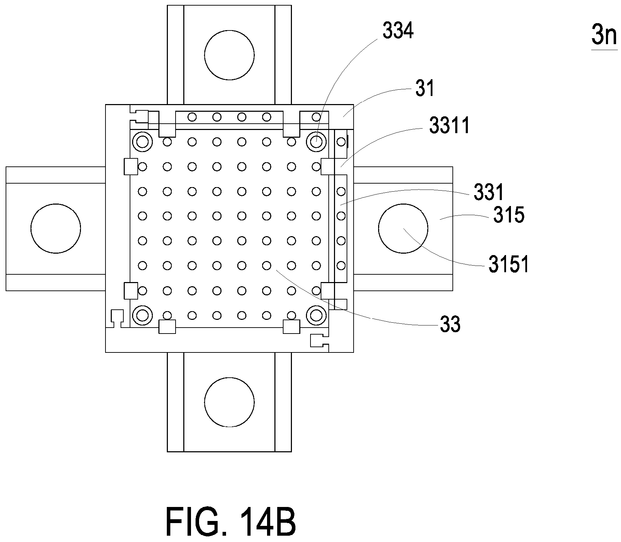

In the above embodiments, the cover 33 can be connected with the first sidewall 31 or the second sidewall 32 by for example but not limited to an integral forming connection, an adhesion connection or a buckle connection. FIG. 14A is a cross sectional view illustrating a power module according to a fourteenth embodiment. FIG. 14B is a top view illustrating the power module of FIG. 14A. In the embodiment, the structures, elements and functions of the modular housing structure 3n are similar to those of the modular housing structure 3h in FIG. 9, and are not redundantly described herein. Different from the modular housing structure 3h of FIG. 9, the first sidewall 31 of the modular housing structure 3n further includes at least an extension portion 315 disposed on the outer side thereof and outwardly extended from the bottom of the first sidewall 31 nearby the substrate 2 so as to fasten the modular housing structure 3n on the surface of an object 4 by for example but not limited to a screw. The object 4 can be for example but not limited to a heatsink, a heat spreader or a cooling system. In the embodiment, the extension portion 315 further includes at least a fixing hole 3151. There is a locking piece 3152, for example but not limited to a screw, passing through the fixing hole 3151 so as to fasten the modular housing structure 3n and the substrate 2 of the power module 2 on the object 4. Certainly, the extension portion 315 is fixed on the object 4 by the above method, but it is not limited thereto. In the embodiment, the first sidewall 31 further includes at least a first fastening element 316 disposed on the upper side of the first sidewall 31. The first fastening element 316 can be for example but not limited to a fitting hook or a buckle and configured to engage with the cover 33 on the upper side of the first sidewall 31 so as to fasten and connect the cover 33 with the first sidewall 31. Moreover, the cover 33 includes a corresponding recess 3311 disposed on the first engaging element 331 so that the first fastening element 316 passes therethrough and fastens the cover 33 on the upper side of the first sidewall 31. Alternatively, in other embodiment, the first fastening element 316 may be disposed on the upper side of the second sidewall 32 and the cover 33 includes the corresponding recess 3311 for allowing the first fastening element to pass therethrough, but it is not limited thereto. It is noted that the cover 33 connected with the first sidewall 31 and the second sidewall 32 by for example but not limited to the above described method, an adhesion connection, a buckle connection or an integral forming connection. Alternatively, in some embodiments, the modular housing structure has the compound 34 constructed by epoxy materials so that the electronic element 21 on the substrate 2 is covered and protected by the compound 34 and the metal terminal 22 is fixed thereon. The cover 33 can be selectively disposed thereon or omitted as shown in FIG. 4.

Further referring to FIGS. 14A and 14B, in the embodiment, the cover 33 of the modular housing structure 3n further includes a second fastening element 334 disposed on the top surface of the cover 33 and configured to fasten the modular housing structure 3n to an attachment (not shown). The attachment can be for example but not limited to a driving board. It is noted that the dispatching location of the second fastening element 334 is not limited to the above embodiment. In other embodiments, the second fastening element 334 is disposed and located according to the dispatching location of the through-opening 333 of the cover 33 or the metal terminal 22 passing therethrough, but it is not limited thereto.

FIG. 15A is a cross sectional view illustrating the cover of the modular housing structure according to a first preferred embodiment of the present invention. FIG. 15B is a top view illustrating the cover of the modular housing structure according to another preferred embodiment of the present invention. As shown in FIGS. 15A and 15B, the cover 33 is similar to the above embodiments. The cover 33 includes a plurality of through-openings 333 for allowing the metal terminal 22 led out from the substrate 2 to pass through the through-opening 333. In the embodiment, the through-openings 333 of the cover 33 are deep through holes and arranged on the cover 33 in arrays. Each through-opening 333 includes an upper through hole 3331, a middle through hole 3332 and a lower through hole 3333 disposed from up to down. The radius of the middle through hole 3332 is smaller than the radii of the upper through hole 3331 and the lower through hole 3333. There is an upper partition 336 between every two upper through holes 3331 to separate one from the other. There is a lower partition 337 between every two lower through holes 3333 to separate one from the other. Each through-opening 333 has at least a middle through hole 3332 for allowing the metal terminal 22 to pass therethrough. The metal terminal 22 may contact with the inner wall of the middle through hole 3332 but not to contact with the upper partition 336 or the lower partition 337. Namely, the upper partition 336 and the lower partition 337 provide the electrical creepage path meeting a specific standard and improve the mechanical strength of the cover 33. In the embodiment, the cover 33 further includes at least a protruding portion 335 disposed on the lower surface of the cover 33, accommodated in the accommodation space 10 of the power module 1 and configured to push against the substrate 2 so as to provide the mechanical support.

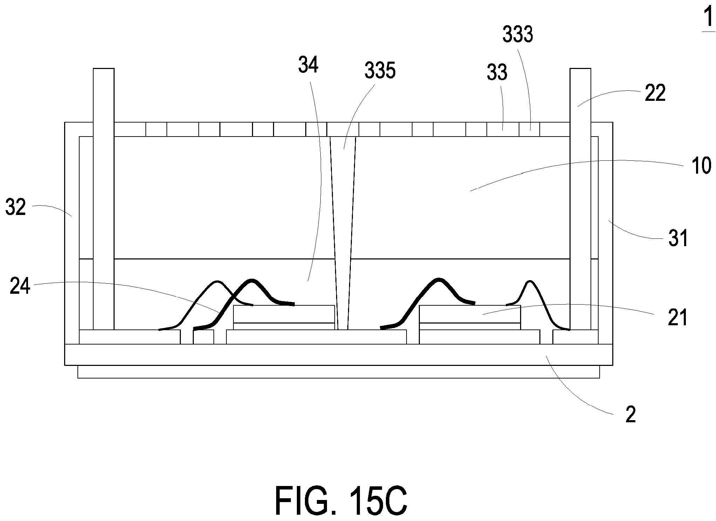

FIG. 15C is a cross sectional view illustrating a power module according to a fifteenth embodiment. In the embodiment, the structures, elements and functions of the power module 1 are similar to those of the power module 1 in FIGS. 1A to ID, and are not redundantly described herein. Different from the power module 1 of FIGS. 1A to 1D, the cover 33 of the power module 1 further includes a protruding portion 335 disposed on the lower surface of the cover 33, accommodated in the accommodation space 10 of the power module 1 and configured to push against the substrate 2 so as to provide the mechanical support. It is noted that the dispatching location and the protruding length of the protruding portion 335 are not limited to the above embodiment and can be adjusted according to the dispatching location of the electronic element 21 on the substrate 2.

In summary, the present disclosure provides a power module having a modular housing structure. The modular housing structure has flexible number sidewalls configured to provide an adjustable assembly according to the size of substrate, so as to prevent from the waste of space and enhance the power density. While developing the new topology or power level, there is no need of remolding a new outer housing structure for accommodating a larger substrate, and the space waste caused by accommodating a smaller substrate within the larger outer housing structure can be prevented. Consequently, the entire manufacturing cost can be reduced, the power density of the power module can be enhanced, and the product will be more competitive. On the other hand, the modular housing structure includes modular and extendable sidewalls and covers, which are configured to package different substrates with varied sizes, so as to accomplishing the entire structure with optimized strength and high power density.

## Claims

1. A power module (1) comprising :
a substrate (2) having an electronic element (21) and at least one metal terminal (22) disposed on a top surface thereof; and
a modular housing structure (3) disposed on the substrate (2) and located around the electronic element (21), wherein the modular housing structure (3, 3a, 3b, 3c, 3d, 3e, 3f, 3g, 3h, 3i, 3j, 3k, 3m, 3n) comprises a plurality of sidewalls (31, 32, 35, 36) configured to connect with each other detachably, and each sidewall (31, 32, 35, 36) comprises two connecting elements (311, 312, 321, 322, 351, 352, 361, 362) disposed on two opposite ends thereof respectively, wherein the two connecting elements (311, 312, 321, 322, 351, 352, 361, 362) of any one of the sidewalls (31, 32, 35, 36) are connected to two corresponding connecting elements (311, 312, 321, 322, 351, 352, 361, 362) of two adjacent sidewalls (31, 32, 35, 36) respectively, wherein the modular housing structure (3, 3a, 3b, 3c, 3d, 3e, 3f, 3g, 3h, 3i, 3i, 3k, 3m, 3n) further comprises at least one cover (33, 37) opposite to the substrate (2) and connected to the plurality of sidewalls (31, 32, 35, 36), wherein the cover (33) comprises at least one through-opening (333), and the metal terminal (22) is connected with the substrate (2) and passes through the through-opening (333) of the cover (33), wherein the through-opening (333) comprises an upper through hole (3331), a middle through hole (3332) and a lower through hole (3333), wherein the radius of the middle through hole (3332) is smaller than the radii of the upper through hole (3331) and the lower through hole (3333).

2. The power module (1) according to claim 1, wherein the plurality of sidewalls (31, 32, 35, 36) comprise at least two first sidewalls (31), and each first sidewall (31) comprises a first connecting element (311) and a second connecting element (312) disposed on the two opposite ends thereof respectively, wherein the first connecting element (311) and the second connecting element (312) are matching structures configured to engage and connect with each other.

3. The power module (1) according to claim 2, wherein the first connecting element (311) of any one of the first sidewalls (31) is connected with the corresponding second connecting element (312) disposed on another one of the first sidewalls (31), and the second connecting element (312) of any one of the first sidewalls (31) is connected with the corresponding first connecting element (311) disposed on another one of the first sidewalls (31), so as to detachably assemble the at least two first sidewalls (31) located around at least four sides of the substrate (2).

4. The power module (1) according to claim 2, wherein the plurality of sidewalls (31, 32, 35, 36) further comprise at least two second sidewalls (32), and each second sidewall (32) comprises a third connecting element (321) and a fourth connecting element (322) disposed on the two opposite ends thereof respectively, wherein the structure of the third connecting element (321) is matching and configured to engage and connect with the structures of the fourth connecting element (322) of the second sidewall (32) and the first connecting element (311) of the first sidewall (31), and the structure of the fourth connecting element (322) is matching and configured to engage and connect with the structures of the third connecting element (321) of the second sidewall (32) and the second connecting element (312) of the first sidewall (31).

5. The power module according to claim 4, wherein the first sidewalls (31) and the second sidewalls (32) are connected in an alternating arrangement and located around at least four sides of the substrate (2), wherein the third connecting element (321) of each one of the second sidewalls (32) is connected to the first connecting element (311) of one of the adjacent first sidewalls (31), and the fourth connecting element (322) of each one of the second sidewalls (32) is connected to the second connecting element (312) of one of the adjacent first sidewalls (31), so as to assemble the first sidewalls (31) and the second sidewalls (32) detachably.

6. The power module (1) according to claim 4 or 5, wherein the number of second sidewalls (32) is at least four, the at least two first sidewalls (31) and the at least four second sidewalls (32) are connected with each other and located around at least four sides of the substrate (2), wherein the third connecting element (321) of any one of the second sidewalls (32) is connected to the first connecting element (311) of one of the adjacent first sidewall (31) or the fourth connecting element (322) of one of the adjacent second sidewall (32), and the fourth connecting element (322) of any one of the second sidewalls (32) is connected to the second connecting element (312) of one of the adjacent first sidewall (31) or the third connecting element (321) of one of the adjacent second sidewall (32), so as to assemble the at least two first sidewalls (31) and the at least four second sidewalls (32) detachably.

7. The power module (1) according to any of the claims 4 to 6, wherein the plurality of sidewalls (31, 32, 35, 36) further comprise:
at least one third sidewall (35), wherein the third sidewall (35) comprises a fifth connecting element (351) and a sixth connecting element (352) disposed on two ends thereof respectively, wherein the structure of the fifth connecting element (351) is matching and configured to engage and connect with the structures of the sixth connecting element (352), the second connecting elements (312) of the first sidewalls (31), and the third connecting elements (321) of the second sidewalls (32), and the structure of the sixth connecting element (352) is matching and configured to engage and connect with the structures of the fifth connecting element (351), the first connecting elements (311) of the first sidewalls (31), and the fourth connecting elements (322) of the second sidewalls (32); and
at least one fourth sidewall (36), wherein the fourth sidewall (36) comprises a seventh connecting element (361) and an eighth connecting element (362) disposed on two ends thereof respectively, wherein the structure of the seventh connecting element (361) is matching and configured to engage and connect with the structures of the eighth connecting element (362), the first connecting elements (311) of the first sidewalls (31), the fourth connecting elements (322) of the second sidewalls (32), and the fifth connecting element (351) of the third sidewall (35), and the structure of the eighth connecting element (362) is matching and configured to engage and connect with the structures of the seventh connecting element (361), the second connecting elements (312) of the first sidewalls (31), the third connecting elements (321) of the second sidewalls (32), and the sixth connecting element (352) of the third sidewall (35).

8. The power module (1) according to any of the claims 4 to 6, wherein the plural sidewalls (31, 32) are configured to define an accommodation space (10) and the modular housing structure further comprises at least an auxiliary wall (38) disposed in the accommodation space (10) and connected to at least one of the plural sidewalls (31, 32), wherein each auxiliary wall (38) comprises two first auxiliary connecting elements (381) and two second auxiliary connecting elements (382), wherein the two first auxiliary connecting elements (381) are disposed on two ends of the auxiliary wall (38) respectively, and the two second auxiliary connecting elements (382) are disposed on two ends of the auxiliary wall (38), respectively, wherein each first sidewall (31) comprises a third auxiliary connecting element (313) and a fourth auxiliary connecting element (314) disposed on two ends thereof respectively, and each second sidewall (32) comprises a fifth auxiliary connecting element (323) and a sixth auxiliary connecting element (324) disposed on two ends thereof respectively, wherein the structure of the first auxiliary connecting element (381) of the auxiliary wall (38) is matching and configured to engage and connect with the structures of the second auxiliary connecting element (382) of the auxiliary wall (38) and the sixth auxiliary connecting element (324) of the second sidewall (32), the structure of the second auxiliary connecting element (382) of the auxiliary wall (38) is matching and configured to engage and connect with the structures of the first auxiliary connecting element (381) of the auxiliary wall (38) and the fourth auxiliary connecting element (314) of the first sidewall (31), and the structure of the third auxiliary connecting element (313) of the first sidewall (31) is matching and configured to engage and connect with the structure of the fifth auxiliary connecting element (323) of the second sidewall (32).

9. The power module (1) according to claim 8, wherein the modular housing structure (3m) further comprises at least four auxiliary walls (38) and the two ends of each of the auxiliary walls (38) comprise a first end and a second end, wherein the first auxiliary connecting element (381) disposed on the first end of any one of the auxiliary walls (38) is connected to the second auxiliary connecting element (382) of another one of the auxiliary walls (38), the second auxiliary connecting element (382) disposed on the first end of any one of the auxiliary walls (38) is connected to the first auxiliary connecting element (381) of another one of the auxiliary walls (38), the first auxiliary connecting element (381) disposed on the second end of any one of the auxiliary walls (38) is connected to the sixth auxiliary connecting element (324) of the second wall (32), and the second auxiliary connecting element (382) disposed on the second end of any one of the auxiliary walls (38) is connected to the fourth auxiliary connecting element (314) of the first sidewall (31), wherein the third auxiliary connecting element (313) of each of the first sidewall (31) is configured to connect with the fifth auxiliary connecting element (323) of the second sidewall (32).

10. The power module (1) according to claim 1, wherein the cover (33) comprises two first sides (330) opposite to each other, and at least two sidewalls (31) of the plurality of sidewalls (31, 32) are integrated with the cover (33) and disposed on the two opposite first sides (330) of the cover (33).

11. The power module (1) according to claim 10, wherein each sidewall of the at least two sidewalls integrated with the cover comprises at least a first fastening element (316) disposed on an upper side of the sidewall (31) so as to fasten the cover (33) on the upper side of the sidewall (31).

12. The power module according to any of the claims 10 to 11, wherein the modular housing structure (3, 3a, 3b, 3c, 3d, 3e, 3f, 3g, 3h, 3i, 3j, 3k, 3m, 3n) further comprises a plurality of covers (33) and each cover (33) comprises two first engaging elements (331) and two second engaging elements (332), wherein the two first engaging elements (331) are disposed on two adjacent sides of the cover (33) and the two second engaging element (332) are disposed on the other two adjacent sides of the cover (33), wherein the first engaging element (331) of any one of the covers (33) is configured to connect with the second engaging element (332) of another one of the covers (3).

13. The power module (1) according to any of the claims 10 to 12, wherein the cover further comprises a second fastening element (334) disposed on a top surface of the cover (33) and configured to fasten the power module (1) to an attachment, and further comprises at least a protruding portion (335) disposed on a lower surface of the cover (33) and configured to contact the substrate (2).

## Patentansprüche

1. Ein Leistungsmodul (1), umfassend :
ein Substrat (2) mit einem elektronischen Element (21) und mindestens einem Metallanschluss (22), der auf einer oberen Oberfläche davon angeordnet ist; und
eine modulare Gehäusestruktur (3), die auf dem Substrat (2) angeordnet ist und sich um das elektronische Element (21) herum befindet, wobei die modulare Gehäusestruktur (3, 3a, 3b, 3c, 3d, 3e, 3f, 3g, 3h, 3i, 3j, 3k, 3m, 3n) eine Vielzahl von Seitenwänden (31, 32, 35, 36) umfasst, die so konfiguriert sind, dass sie lösbar miteinander verbunden werden können, und jede Seitenwand (31, 32, 35, 36) zwei Verbindungselemente (311) umfasst, 312, 321, 322, 351, 352, 361, 362), die jeweils an zwei gegenüberliegenden Enden davon angeordnet sind, wobei die beiden Verbindungselemente (311, 312, 321, 322, 351, 352, 361, 362) einer der Seitenwände (31, 32, 35, 36) mit zwei entsprechenden Verbindungselementen (311, 312, 321, 322, 351, 352, 361, 362) zweier benachbarter Seitenwände (31, 32, 35) verbunden sind, 36), wobei die modulare Gehäusestruktur (3, 3a, 3b, 3c, 3d, 3e, 3f, 3g, 3h, 3i, 3j, 3k, 3m, 3n) ferner mindestens eine Abdeckung (33, 37) aufweist, die dem Substrat (2) gegenüberliegt und mit der Vielzahl von Seitenwänden (31, 32, 35, 36) verbunden ist, wobei die Abdeckung (33) mindestens eine Durchgangsöffnung (333) aufweist, und der Metallanschluss (22) mit dem Substrat (2) verbunden ist und durch die Durchgangsöffnung (333) der Abdeckung (33) hindurchgeht, wobei die Durchgangsöffnung (333) ein oberes Durchgangsloch (3331), ein mittleres Durchgangsloch (3332) und ein unteres Durchgangsloch (3333) umfasst, wobei der Radius des mittleren Durchgangslochs (3332) kleiner ist als die Radien des oberen Durchgangslochs (3331) und des unteren Durchgangslochs (3333).

2. Das Leistungsmodul (1) nach Anspruch 1, wobei die Mehrzahl von Seitenwänden (31, 32, 35, 36) mindestens zwei erste Seitenwände (31) umfasst und jede erste Seitenwand (31) ein erstes Verbindungselement (311) und ein zweites Verbindungselement (312) umfasst, die jeweils an ihren beiden gegenüberliegenden Enden angeordnet sind, wobei das erste Verbindungselement (311) und das zweite Verbindungselement (312) zueinander passende Strukturen sind, die so konfiguriert sind, dass sie ineinander eingreifen und miteinander verbunden werden können.

3. Das Leistungsmodul (1) nach Anspruch 2, wobei das erste Verbindungselement (311) einer beliebigen der ersten Seitenwände (31) mit dem entsprechenden zweiten Verbindungselement (312) verbunden ist, das an einer anderen der ersten Seitenwände (31) angeordnet ist, und das zweite Verbindungselement (312) einer beliebigen der ersten Seitenwände (31) mit dem entsprechenden ersten Verbindungselement (311) verbunden ist, das an einer anderen der ersten Seitenwände (31) angeordnet ist, so dass die mindestens zwei ersten Seitenwände (31), die um mindestens vier Seiten des Substrats (2) herum angeordnet sind, lösbar zusammengefügt werden.

4. Das Leistungsmodul (1) nach Anspruch 2, wobei die Mehrzahl von Seitenwänden (31, 32, 35, 36) ferner mindestens zwei zweite Seitenwände (32) umfasst und jede zweite Seitenwand (32) ein drittes Verbindungselement (321) und ein viertes Verbindungselement (322) umfasst, die jeweils an ihren beiden gegenüberliegenden Enden angeordnet sind, wobei die Struktur des dritten Verbindungselements (321) mit den Strukturen des vierten Verbindungselements (322) der zweiten Seitenwand (32) und des ersten Verbindungselements (311) der ersten Seitenwand (31) übereinstimmt und so konfiguriert ist, dass es mit den Strukturen des dritten Verbindungselements (321) der zweiten Seitenwand (32) und des zweiten Verbindungselements (312) der ersten Seitenwand (31) in Eingriff kommt und sich mit diesen verbindet, und wobei die Struktur des vierten Verbindungselements (322) mit den Strukturen des dritten Verbindungselements (321) der zweiten Seitenwand (32) und des zweiten Verbindungselements (312) der ersten Seitenwand (31) übereinstimmt und so konfiguriert ist, dass es mit diesen in Eingriff kommt und sich mit diesen verbindet.

5. Das Leistungsmodul nach Anspruch 4, wobei die ersten Seitenwände (31) und die zweiten Seitenwände (32) in einer abwechselnden Anordnung verbunden sind und um mindestens vier Seiten des Substrats (2) herum angeordnet sind, wobei das dritte Verbindungselement (321) jeder der zweiten Seitenwände (32) mit dem ersten Verbindungselement (311) einer der benachbarten ersten Seitenwände (31) verbunden ist, und das vierte Verbindungselement (322) jeder der zweiten Seitenwände (32) mit dem zweiten Verbindungselement (312) einer der benachbarten ersten Seitenwände (31) verbunden ist, um die ersten Seitenwände (31) und die zweiten Seitenwände (32) lösbar zusammenzufügen.

6. Das Leistungsmodul (1) nach Anspruch 4 oder 5, wobei die Anzahl der zweiten Seitenwände (32) mindestens vier beträgt, die mindestens zwei ersten Seitenwände (31) und die mindestens vier zweiten Seitenwände (32) miteinander verbunden und um mindestens vier Seiten des Substrats (2) herum angeordnet sind, wobei das dritte Verbindungselement (321) einer beliebigen der zweiten Seitenwände (32) mit dem ersten Verbindungselement (311) einer der benachbarten ersten Seitenwände (31) oder dem vierten Verbindungselement (322) einer der benachbarten zweiten Seitenwände (32) verbunden ist, und das vierte Verbindungselement (322) einer beliebigen der zweiten Seitenwände (32) mit dem zweiten Verbindungselement (312) einer der benachbarten ersten Seitenwände (31) oder dem dritten Verbindungselement (321) einer der benachbarten zweiten Seitenwände (32) verbunden ist, um die mindestens zwei ersten Seitenwände (31) und die mindestens vier zweiten Seitenwände (32) lösbar zusammenzufügen.

7. Das Leistungsmodul (1) nach einem der Ansprüche 4 bis 6, wobei die Mehrzahl von Seitenwänden (31, 32, 35, 36) ferner umfasst:
mindestens eine dritte Seitenwand (35), wobei die dritte Seitenwand (35) ein fünftes Verbindungselement (351) und ein sechstes Verbindungselement (352) umfasst, die jeweils an zwei Enden davon angeordnet sind, wobei die Struktur des fünften Verbindungselements (351) mit den Strukturen des sechsten Verbindungselements (352), den zweiten Verbindungselementen (312) der ersten Seitenwände (31), zusammenpasst und so konfiguriert ist, dass sie in die Strukturen des sechsten Verbindungselements (352) eingreift und sich mit diesen verbindet, und die dritten Verbindungselemente (321) der zweiten Seitenwände (32), und die Struktur des sechsten Verbindungselements (352) ist passend und konfiguriert, um mit den Strukturen des fünften Verbindungselements (351), den ersten Verbindungselementen (311) der ersten Seitenwände (31) und den vierten Verbindungselementen (322) der zweiten Seitenwände (32) in Eingriff zu kommen und sich mit ihnen zu verbinden; und
wenigstens eine vierte Seitenwand (36), wobei die vierte Seitenwand (36) ein siebtes Verbindungselement (361) und ein achtes Verbindungselement (362) umfasst, die jeweils an zwei Enden davon angeordnet sind, wobei die Struktur des siebten Verbindungselements (361) mit den Strukturen des achten Verbindungselements (362), den ersten Verbindungselementen (311) der ersten Seitenwände (31) und den vierten Verbindungselementen (322) der zweiten Seitenwände (32) übereinstimmt und so konfiguriert ist, dass sie mit den Strukturen des achten Verbindungselements (362) in Eingriff kommen und sich mit diesen verbinden, und dem fünften Verbindungselement (351) der dritten Seitenwand (35), und die Struktur des achten Verbindungselements (362) ist passend und konfiguriert, um mit den Strukturen des siebten Verbindungselements (361), den zweiten Verbindungselementen (312) der ersten Seitenwände (31), den dritten Verbindungselementen (321) der zweiten Seitenwände (32) und dem sechsten Verbindungselement (352) der dritten Seitenwand (35) in Eingriff zu kommen und sich mit ihnen zu verbinden.

8. Das Leistungsmodul (1) nach einem der Ansprüche 4 bis 6, wobei die mehreren Seitenwände (31, 32) so konfiguriert sind, dass sie einen Aufnahmeraum (10) definieren, und die modulare Gehäusestruktur ferner mindestens eine Hilfswand (38) umfasst, die in dem Aufnahmeraum (10) angeordnet und mit mindestens einer der mehreren Seitenwände (31, 32) verbunden ist, wobei jede Hilfswand (38) zwei erste Hilfsverbindungselemente (381) und zwei zweite Hilfsverbindungselemente (382) umfasst, wobei die zwei ersten Hilfsverbindungselemente (381) jeweils an zwei Enden der Hilfswand (38) angeordnet sind, und die zwei zweiten Hilfsverbindungselemente (382) jeweils an zwei Enden der Hilfswand (38) angeordnet sind, wobei jede erste Seitenwand (31) ein drittes Hilfsverbindungselement (313) und ein viertes Hilfsverbindungselement (314) aufweist, die jeweils an zwei Enden davon angeordnet sind, und jede zweite Seitenwand (32) ein fünftes Hilfsverbindungselement (323) und ein sechstes Hilfsverbindungselement (324) umfasst, die jeweils an zwei Enden davon angeordnet sind, wobei die Struktur des ersten Hilfsverbindungselements (381) der Hilfswand (38) mit den Strukturen des zweiten Hilfsverbindungselements (382) der Hilfswand (38) und des sechsten Hilfsverbindungselements (324) der zweiten Seitenwand (32) übereinstimmt und so konfiguriert ist, dass sie mit diesen in Eingriff kommen und sich mit ihnen verbinden, die Struktur des zweiten Hilfsverbindungselements (382) der Hilfswand (38) mit der Struktur des ersten Hilfsverbindungselements (381) der Hilfswand (38) und des vierten Hilfsverbindungselements (314) der ersten Seitenwand (31) zusammenpasst und so konfiguriert ist, dass sie mit der Struktur des fünften Hilfsverbindungselements (323) der zweiten Seitenwand (32) zusammenpasst und so konfiguriert ist, dass sie mit der Struktur des dritten Hilfsverbindungselements (313) der ersten Seitenwand (31) zusammenpasst und so konfiguriert ist, dass sie mit der Struktur des fünften Hilfsverbindungselements (323) der zweiten Seitenwand (32) zusammenpasst und sich mit dieser verbindet.

9. Das Leistungsmodul (1) nach Anspruch 8, wobei die modulare Gehäusestruktur (3m) ferner mindestens vier Hilfswände (38) umfasst und die beiden Enden jeder der Hilfswände (38) ein erstes Ende und ein zweites Ende aufweisen, wobei das erste Hilfsverbindungselement (381), das an dem ersten Ende einer beliebigen der Hilfswände (38) angeordnet ist, mit dem zweiten Hilfsverbindungselement (382) einer anderen der Hilfswände (38) verbunden ist, das zweite Hilfsverbindungselement (382), das an dem ersten Ende einer beliebigen der Hilfswände (38) angeordnet ist, mit dem ersten Hilfsverbindungselement (381) einer anderen der Hilfswände (38) verbunden ist, das erste Hilfsverbindungselement (381), das an dem zweiten Ende einer der Hilfswände (38) angeordnet ist, mit dem sechsten Hilfsverbindungselement (324) der zweiten Wand (32) verbunden ist, und das zweite Hilfsverbindungselement (382), das an dem zweiten Ende einer der Hilfswände (38) angeordnet ist, mit dem vierten Hilfsverbindungselement (314) der ersten Seitenwand (31) verbunden ist, wobei das dritte Hilfsverbindungselement (313) jeder der ersten Seitenwände (31) so konfiguriert ist, dass es mit dem fünften Hilfsverbindungselement (323) der zweiten Seitenwand (32) verbunden ist.

10. Das Leistungsmodul (1) nach Anspruch 1, wobei die Abdeckung (33) zwei einander gegenüberliegende erste Seiten (330) aufweist und mindestens zwei Seitenwände (31) der Mehrzahl von Seitenwänden (31, 32) mit der Abdeckung (33) integriert und auf den beiden gegenüberliegenden ersten Seiten (330) der Abdeckung (33) angeordnet sind.

11. Das Leistungsmodul (1) nach Anspruch 10, wobei jede Seitenwand der mindestens zwei mit der Abdeckung integrierten Seitenwände mindestens ein erstes Befestigungselement (316) aufweist, das an einer Oberseite der Seitenwand (31) angeordnet ist, um die Abdeckung (33) an der Oberseite der Seitenwand (31) zu befestigen.

12. Das Leistungsmodul nach einem der Ansprüche 10 bis 11, wobei die modulare Gehäusestruktur (3, 3a, 3b, 3c, 3d, 3e, 3f, 3g, 3h, 3i, 3j, 3k, 3m, 3n) ferner eine Vielzahl von Abdeckungen (33) umfasst und jede Abdeckung (33) zwei erste Eingriffselemente (331) und zwei zweite Eingriffselemente (332) aufweist, wobei die zwei ersten Eingriffselemente (331) auf zwei benachbarten Seiten der Abdeckung (33) angeordnet sind und die zwei zweiten Eingriffselemente (332) auf den anderen zwei benachbarten Seiten der Abdeckung (33) angeordnet sind, wobei das erste Eingriffselement (331) irgendeiner der Abdeckungen (33) konfiguriert ist, um mit dem zweiten Eingriffselement (332) einer anderen der Abdeckungen (3) verbunden zu werden.

13. Das Leistungsmodul (1) nach einem der Ansprüche 10 bis 12, wobei die Abdeckung ferner ein zweites Befestigungselement (334) umfasst, das auf einer oberen Oberfläche der Abdeckung (33) angeordnet und konfiguriert ist, um das Leistungsmodul (1) an einer Befestigung zu befestigen, und ferner mindestens einen vorstehenden Abschnitt (335) umfasst, der auf einer unteren Oberfläche der Abdeckung (33) angeordnet und konfiguriert ist, um das Substrat (2) zu kontaktieren.

## Revendications

1. Un module de puissance (1) comprenant:
un substrat (2) ayant un élément électronique (21) et au moins une borne métallique (22) ; disposée sur une surface supérieure de celui-ci; et
une structure de boîtier modulaire (3) disposée sur le substrat (2) et située autour de l'élément électronique (21), dans laquelle la structure de boîtier modulaire (3, 3a, 3b, 3c, 3d, 3e, 3f, 3g, 3h, 3i , 3j, 3k, 3m, 3n) comprend une pluralité de parois latérales (31, 32, 35, 36) configurées pour se connecter les unes aux autres de manière amovible, et chaque paroi latérale (31, 32, 35, 36) comprend deux éléments de liaison (311, 312, 321, 322, 351, 352, 361, 362) disposés respectivement sur deux extrémités opposées de celui-ci, dans lequel les deux éléments de liaison (311, 312, 321, 322, 351, 352, 361, 362) de l'une quelconque des parois latérales (31, 32, 35, 36) sont connectés à deux éléments de liaison correspondants (311, 312, 321, 322, 351, 352, 361, 362) de deux parois latérales adjacentes (31, 32, 35, 36) respectivement, dans lequel la structure de boîtier modulaire (3, 3a, 3b, 3c, 3d, 3e, 3f, 3g, 3h, 3i, 3j, 3k, 3m, 3n) comprend en outre au moins un couvercle (33, 37) opposé au substrat (2) et relié à la pluralité de parois latérales (31, 32, 35, 36), dans lequel le couvercle (33) comprend au moins un trou traversant (333), et la borne métallique (22) est connectée au substrat (2) et passe à travers le trou traversant (333) du couvercle (33), dans lequel le trou traversant (333) comprend un trou traversant supérieur (3331), un trou traversant médian (3332) et trou traversant inférieur (3333), dans lequel le rayon du trou traversant médian (3332) est plus petit que les rayons du trou traversant supérieur (3331) et du trou traversant inférieur (3333).

2. Le module de puissance (1) selon la revendication 1, dans lequel la pluralité de parois latérales (31, 32, 35, 36) comprend au moins deux premières parois latérales (31), et chacune des premières parois latérales (31) comprend un premier élément de liaison (311) et un deuxième élément de liaison (312) disposés respectivement sur ses deux extrémités opposées, dans lequel le premier élément de liaison (311) et le deuxième élément de liaison (312) sont des structures correspondantes l'un à l'autre.

3. Le module de puissance (1) selon la revendication 2, dans lequel le premier élément de liaison (311) de l'une quelconque des premières parois latérales (31) est lié au deuxième élément de liaison correspondant (312) disposé sur une autre des premières parois latérales (31), et le deuxième élément de liaison (312) de l'une quelconque des premières parois latérales (31) est relié au premier élément de liaison correspondant (311) disposé sur une autre des premières parois latérales (31), de manière à assembler de manière détachable les au moins deux premières parois latérales (31) situées autour d'au moins quatre côtés du substrat (2).

4. Le module de puissance (1) selon la revendication 2, dans lequel la pluralité de parois latérales (31, 32, 35, 36) comprend en outre au moins deux secondes parois latérales (32), et chaque seconde paroi latérale (32) comprend un troisième élément de liaison (321) et un quatrième élément de liaison (322) disposés respectivement sur les deux extrémités opposées de celui-ci, dans lequel la structure du troisième élément de liaison (321) est adaptée et configurée pour être en prise et se lier avec les structures du quatrième élément de liaison (322) de la deuxième paroi latérale (32) et le premier élément de liaison (311) de la première paroi latérale (31), et la structure du quatrième élément de liaison (322) est adaptée et configurée pour être en prise et se relier aux structures du troisième élément de liaison (321) de la deuxième paroi latérale (32) et du deuxième élément de liaison (312) de la première paroi latérale (31).

5. Le module de puissance selon la revendication 4, dans lequel les premières parois latérales (31) et les secondes parois latérales (32) sont reliées suivant un agencement d'alternance et situées autour d'au moins quatre côtés du substrat (2), dans lequel le troisième élément de liaison (321) de chacune des secondes parois latérales (32) est relié au premier élément de liaison (311) de l'une des premières parois latérales adjacentes (31), et le quatrième élément de liaison (322) de chacune des secondes parois latérales (32) est relié au deuxième élément de liaison (312) de l'une des premières parois latérales adjacentes (31), de manière à assembler les premières parois latérales (31) et les secondes parois latérales (32) de manière amovible.

6. Le module de puissance (1) selon la revendication 4 ou 5, dans lequel le nombre de secondes parois latérales (32) est d'au moins quatre, les au moins deux premières parois latérales (31) et les au moins quatre secondes parois latérales (32) sont reliées l'une à l'autre et situées autour d'au moins quatre côtés du substrat (2), dans lequel le troisième élément de liaison (321) de l'une quelconque des secondes parois latérales (32) est relié au premier élément de liaison (311) de l'une des premières parois latérales adjacentes (31) ou le quatrième élément de liaison (322) de l'une des secondes parois latérales adjacentes (32), et le quatrième élément de liaison (322) de l'une quelconque des secondes parois latérales (32) est relié au second élément de liaison (312) de l'une de la première paroi latérale adjacente (31) ou du troisième élément de liaison (321) de l'une des secondes parois latérales adjacentes (32), de manière à assembler les au moins deux premières parois latérales (31) et les au moins quatre secondes parois latérales (32) de manière amovible.

7. Le module de puissance (1) selon l'une quelconque des revendications 4 à 6, dans lequel la pluralité de parois latérales (31, 32, 35, 36) comprend en outre:
au moins une troisième paroi latérale (35), dans lequel la troisième paroi latérale (35) comprend un cinquième élément de liaison (351) et un sixième élément de liaison (352) disposés respectivement à deux de ses extrémités, dans lequel la structure du cinquième élément de liaison (351) correspond et est configuré pour être en prise et en liaison avec les structures du sixième élément de liaison (352), les deuxième éléments de liaison (312) des premières parois latérales (31), et des troisièmes éléments de liaison (321) des deuxièmes parois latérales (32), et la structure du sixième élément de liaison (352) est adaptée et configurée pour être en prise et en liaison avec les structures du cinquième élément de liaison (351), les premiers éléments de liaison (311) des premières parois latérales (31) et les quatrièmes éléments de liaison (322) des secondes parois latérales (32); et
au moins une quatrième paroi latérale (36), dans laquelle la quatrième paroi latérale (36) comprend un septième élément de liaison (361) et un huitième élément de liaison (362) disposés respectivement à ses deux extrémités, dans lequel la structure du septième élément de liaison (361 s'adapte et est configuré pour être en prise et en liaison avec les structures du huitième élément de liaison (362), des premiers éléments de liaison (311) des premières parois latérales (31), des quatrièmes éléments de liaison (322) des secondes parois latérales (32) et du cinquième élément de liaison (351) de la troisième paroi latérale (35), et la structure du huitième élément de liaison (362) est adaptée et configurée pour être en prise et en liaison avec les structures du septième élément de liaison (361), des seconds éléments de liaison (312) des premières parois latérales (31), des troisièmes éléments de liaison (321) des deuxièmes parois latérales (32) et du sixième élément de liaison (352) de la troisième paroi latérale (35).

8. Le module de puissance (1) selon l'une quelconque des revendications 4 à 6, dans lequel les multiples parois latérales (31, 32) sont configurées pour définir un espace de logement (10) et la structure de logement modulaire comprend en outre au moins une paroi auxiliaire (38) disposée dans l'espace de logement (10) et reliée à l'une au moins parmi les multiples parois latérales (31, 32), dans lequel chaque paroi auxiliaire (38) comporte deux premiers éléments de liaison auxiliaires (381) et deux seconds éléments de liaison auxiliaires (382), dans lequel les deux premiers éléments de liaison auxiliaires sont disposés sur deux extrémités de la paroi auxiliaire (38) respectivement, et les deux seconds éléments de liaison auxiliaires (382) sont disposées sur deux extrémités de la paroi auxiliaire (38), respectivement, dans lequel chaque première paroi latérale (31) comporte un troisième élément de liaison auxiliaire(313) et un quatrième élément de liaison auxiliaire (314) disposés sur deux extrémités respectivement, et chaque seconde paroi latérale (32) comporte un cinquième élément de liaison auxiliaire (323) et un sixième élément de liaison auxiliaire (324) disposés sur deux extrémités respectivement, dans lequel la structure du premier élément de liaison auxiliaire (381) de la paroi auxiliaire (38) correspond et est configuré pour être en prise et relié aux structures du second élément de liaison auxiliaire (382) de la paroi auxiliaire (38) et du sixième élément de liaison auxiliaire (324) de la seconde paroi latérale (32), la structure du second élément de liaison auxiliaire (382) de la paroi auxiliaire (38) correspond et est configuré pour être en prise et relié aux structure du premier élément de liaison auxiliaire (381) de la paroi auxiliaire (38) et du quatrième élément de liaison auxiliaire (314) de la première paroi latérale (31), et la structure du troisième élément de liaison auxiliaire (313) de la première paroi latérale (31) correspond et est configuré pour être en prise et relié à la structure du cinquième élément de liaison auxiliaire (323) de la seconde paroi latérale (32).

9. Le module de puissance (1) selon la revendication 8, dans lequel la structure de logement modulaire (3m) comporte en outre au moins quatre parois auxiliaire (38) et les deux extrémités de chacune des parois auxiliaires (38) comportent une première extrémité et une seconde extrémité, dans lequel le premier élément de liaison auxiliaire (381) disposé sur la première extrémité de l'une quelconque des parois auxiliaires (38) est relié au deuxième élément de liaison auxiliaire (382) d'une autre paroi auxiliaire (38), le deuxième élément de liaison auxiliaire (382) disposé sur la première extrémité de l'une quelconque des parois auxiliaires (38) est relié au premier élément de liaison auxiliaire (381) d'une autre paroi auxiliaire (38), le premier élément de liaison auxiliaire (381) disposé sur la seconde extrémité de l'une quelconque des parois auxiliaires (38) est relié au sixième élément de liaison auxiliaire (324) de la deuxième paroi (32), et le deuxième élément de liaison auxiliaire (382) disposé sur la deuxième extrémité de l'une quelconque des parois auxiliaires (38) est connecté au quatrième élément de liaison auxiliaire (314) de la première paroi latérale (31), dans laquelle le troisième élément de liaison auxiliaire (313) de chaque première paroi latérale (31) est configuré pour se relier au cinquième élément de liaison auxiliaire (323) de la deuxième paroi latérale (32).

10. Le module de puissance (1) selon la revendication 1, dans lequel le couvercle (33) comprend deux premiers côtés (330) opposés l'un à l'autre, et au moins deux parois latérales (31) parmi la pluralité de parois latérales (31, 32) sont intégrées avec le couvercle (33) et disposé sur les deux premiers côtés opposés (330) du couvercle (33).

11. Le module de puissance (1) selon la revendication 10, dans lequel chaque paroi latérale des deux parois latérales au moins intégrées au couvercle comportent au moins un premier élément de fixation (316) disposé sur un côté supérieur de la paroi latérale (31).

12. Le module de puissance selon l'une quelconque des revendications 10 à 11, dans lequel la structure de boîtier modulaire (3, 3a, 3b, 3c, 3d, 3e, 3f, 3g, 3h, 3i, 3j, 3k, 3m, 3n) comprend en outre un pluralité de couvercles (33) et chaque couvercle (33) comprend deux premiers éléments d'engagement (331) et deux seconds éléments d'engagement (332), les deux premiers éléments d'engagement (331) étant disposés sur deux côtés adjacents du couvercle (33) et les deux seconds éléments d'engagement (332) sont disposés sur les deux autres côtés adjacents du couvercle (33), dans lequel le premier élément d'engagement (331) de l'un quelconque des couvercles (33) est configuré pour une liaison avec le deuxième élément d'engagement. (332) d'un autre des couvercles (3).

13. Le module de puissance (1) selon l'une quelconque des revendications 10 à 12, dans lequel le couvercle comprend en outre un deuxième élément de fixation (334) disposé sur une surface supérieure du couvercle (33) et configuré pour fixer le module d'alimentation (1) à une fixation et comprend en outre au moins une partie en saillie (335) disposée sur une surface inférieure du couvercle (33) et configurée pour entrer en contact avec le substrat (2).
